(19) Europäisches Patentamt
European Patent Office
Office européen des brevets

(11) **EP 3 327 936 B1**

(12) **FASCICULE DE BREVET EUROPEEN**

(45) Date de publication et mention
de la délivrance du brevet:
**21.04.2021 Bulletin 2021/16**

(51) Int Cl.:
***H03M 13/03*** *(2006.01)*     ***H03M 13/11*** *(2006.01)*

(21) Numéro de dépôt: **16306546.9**

(22) Date de dépôt: **23.11.2016**

(54) **CODAGE/DÉCODAGE PAR CODE LDPC QUASI-CYCLIQUE SEMI-RÉGULIER DE COURTE LONGUEUR POUR APPLICATIONS À FAIBLE CONSOMMATION TELLES QUE LA TÉLÉRELÈVE**

CODIERUNG/DECODIERUNG MIT QUASIZYKLISCHEN SEMIREGULÄREN KURZEN LDPC-CODES FÜR ANWENDUNGEN MIT GERINGEM VERBRAUCH, WIE ETWA FERNERFASSUNG

CODING/DECODING WITH SHORT QUASI-CYCLIC SEMI-REGULAR LDPC CODES FOR LOW CONSUMPTION APPLICATIONS SUCH AS REMOTE METER READING

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(43) Date de publication de la demande:
**30.05.2018 Bulletin 2018/22**

(73) Titulaires:
• **SUEZ Groupe**
**92040 Paris la Défense Cedex (FR)**
• **GRDF**
**75009 Paris (FR)**

(72) Inventeur: **DORNSTETTER, Jean-Louis**
**78460 Choisel (FR)**

(74) Mandataire: **Marks & Clerk France**
**Immeuble "Visium"**
**22, avenue Aristide Briand**
**94117 Arcueil Cedex (FR)**

(56) Documents cités:
• **DARIUSH DIVSALAR ET AL: "Short Protograph-Based LDPC Codes", MILITARY COMMUNICATIONS CONFERENCE, 2007. MILCOM 2007. IEEE, IEEE, PISCATAWAY, NJ, USA, 29 octobre 2007 (2007-10-29), pages 1-6, XP031232390, ISBN: 978-1-4244-1512-0**

**Description**

DOMAINE DE L'INVENTION

La présente invention concerne le domaine des codes correcteurs d'erreur. Il concerne plus spécifiquement les codes LDPC permettant d'émettre des signaux avec une faible consommation énergétique et une faible complexité de décodage, tout en conservant de bonnes propriétés de correction d'erreur, notamment pour la transmission de données de télérelève de compteurs d'eau ou d'énergie.

ETAT DE L'ART PRECEDENT

La transmission de données peut se faire par différents canaux de communication, par exemple par communication radio, fibre optique, etc... Dans la grande majorité des cas, le canal de transmission n'est pas complètement fiable, et la transmission peut être entachée d'erreurs. De manière générale, plus le Rapport Signal à Bruit, ou SNR (de l'acronyme anglais Signal to Noise Ratio) du canal de transmission est faible, plus le canal est bruité est plus le taux d'erreurs est élevé.

Les codes correcteurs d'erreurs permettent, en ajoutant des bits de redondance au signal à encoder, de détecter et corriger les erreurs de transmission. De nombreux codes correcteurs d'erreurs existent. De manière générale, ils visent à obtenir un taux de détection et/ou de correction d'erreur maximal, tout en ajoutant le moins de bits de redondance possible. Selon les applications, il peut également être important de limiter la complexité d'encodage et/ou de décodage du code correcteur d'erreurs.

Les codes dits LDPC (de l'acronyme anglais Low Density Parity check Code, ou Code à contrôles de Parité de Basse Densité) sont une famille de codes correcteurs d'erreurs. Les codes LDPC sont populaires pour la transmission de données sur des canaux particulièrement bruités. Ils sont notamment utilisés comme codes correcteurs d'erreurs dans le standard DVB-S2.

Les codes LDPC sont représentés par un graphe bipartite, dit de Tanner, formé de nœuds variables et de nœuds contraintes. Lors du décodage, une ou plusieurs itérations permettent successivement de vérifier si le message est transmis sans erreur, et, en cas d'erreur(s), de corriger celle(s)-ci. Les codes de type LDPC sont par exemple introduits par Davey, M. C., & MacKay, D. J. (1998, June). Low density parity check codes over GF (q). In Information Theory Workshop, 1998 (pp. 70-71). IEEE.

La télérelève, par exemple de compteurs d'eau, ou d'énergie du type gaz ou électricité, consiste à récupérer à distance des informations issues de chaque compteur, et ce de manière périodique, par exemple des consommations journalières. La télérelève présente de nombreux avantages par rapport à une relève manuelle des consommations: les données sont transmises plus régulièrement, et la relève à distance permet de récupérer des valeurs issues de capteurs difficilement accessibles à un opérateur. De plus, l'envoi automatique et distant de valeurs de consommation est une solution plus économe et rapide que le relevé manuel des compteurs. De manière générale, dans la télérelève, des compteurs envoient de manière régulière des données de consommation à des concentrateurs par une liaison radio, et les concentrateurs transmettent ces données à une plateforme de traitement.

La télérelève de ce type de compteurs présente des difficultés particulières : les compteurs sont souvent dans des zones difficilement accessibles, et sont souvent alimentés par une pile électrique. Le compteur est alors prévu pour fonctionner de manière autonome pendant une durée longue, par exemple de l'ordre de 20 ans, sans intervention. Afin de préserver la durée de vie de la pile, ce type de compteur réduit généralement la puissance d'émission afin de limiter la consommation due à l'émission de données. Cependant, ceci conduit à l'obtention, par le récepteur, d'un signal très bruité.

Les codes LDPC de l'état de l'art présentent le désavantage d'augmenter de manière importante l'énergie consommée par bit utile transmis. De plus, la plupart des codes LDPC de l'état de l'art sont des codes longs. Ces codes longs nécessitent donc de nombreuses itérations de décodage. Cela rend le nombre d'opérations à effectuer pour le décodage élevé, et donc le décodage complexe. De plus, les codes longs peuvent, lorsque la taille des trames utiles à transmettre est faible, entraîner une augmentation de la taille du bloc indue, pour pouvoir coder les données.

SHORT PROTOGRAPH-BASED LDPC CODES, Dariush Divsalar, Sam Dolinar et Christopher Jones, Military Communications Conférence, 2007. MILCOM 2007. IEEE, section IV. divulgue un code LDPC comprenant 128 nœuds variables, 64 nœuds contraintes, et pour lequel chaque nœud contrainte est lié à 7 nœuds variable. Ces codes LDPC présentent de bonnes capacités de correction d'erreur. Cependant, la distance minimale du code est égale à 12.

Il y a donc besoin d'un Code correcteur d'erreurs, permettant de réduire, à l'encodage, l'énergie consommée par bit utile transmis, tout en conservant une complexité de décodage limitée, et un bon taux de correction d'erreurs pour des signaux fortement bruités.

RESUME DE L'INVENTION

A cet effet, l'invention décrit un encodeur LDPC (Contrôle de Parité de Basse Densité) configuré pour encoder des signaux en utilisant un code LDPC caractérisé en ce qu'il admet une matrice de contrôle représentée par un graphe bipartite de Tanner composé de 128 nœuds variables du graphe et 64 nœuds contraintes du graphe, ledit graphe étant tel que : chacun des nœuds contraintes du graphe est connecté à exactement 7 nœuds variables du graphe; chacun des cycles du graphe a une longueur supérieure ou égale à 6 ; dans lequel ledit graphe bipartite de Tanner est un graphe dérivé d'un protographe, ledit protographe comprenant 8 nœuds variables du protographe, chaque nœud variable du protographe étant un groupe de 16 nœuds variables du graphe et 4 nœuds contraintes du protographe, chaque nœud contrainte du protographe étant un groupe de 16 nœuds contraintes du graphe, dans lequel chaque nœud contrainte du protographe est relié à 7 desdits nœuds variables du protographe selon une matrice, chaque nœud contrainte étant représenté par une ligne de la matrice, chaque nœud variable étant représenté par une colonne de la matrice, chaque cellule de la matrice, définie sur une ligne et une colonne, comprenant la valeur 1 lorsque le nœud variable représenté par la ligne de la cellule et le nœud contrainte représenté par la colonne de la cellule sont reliés, et la valeur 0 dans le cas contraire, ladite matrice étant définie par les valeurs :

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

ledit encodeur LDPC étant caractérisé en ce que la distance minimale du code est égale à 14

Un nœud variable du graphe correspond à un bit de données encodées, pouvant être un bit de données utiles ou un bit de redondance.

Un nœud contrainte du graphe définit une contrainte à vérifier sur les nœuds variables auxquels il est connecté.

Une arête du graphe représente une liaison entre un nœud contrainte du graphe et un nœud variable du graphe.

Un cycle est une suite d'arêtes ayant le même nœud pour origine et pour fin.

La longueur d'un cycle est le nombre d'arêtes dans la suite d'arêtes formant le cycle.

Un code LDPC selon l'invention est un code dit court, c'est-à-dire présentant un nombre de nœuds variables faible comparé aux codes habituellement utilisés. Cela lui permet d'être décodé avec un nombre limité d'itérations, le décodage d'un code LDPC selon l'invention est donc peu complexe.

Un code LDPC selon l'invention comprend deux fois plus de nœuds variables que de nœuds contraintes, et chaque nœud contrainte est relié à 7 nœuds variables. Ceci permet de relier chaque nœud variable à au moins 3 nœuds contraintes, et d'éviter la présence de configurations autobloquantes pouvant survenir en présence de nœuds variables de degré 2.

Par ailleurs, les familles les plus connues de codes LDPC, telle que par exemple les familles divulguées par Gallager, R. (1962). Low-density parity-check codes. IRE Transactions on information theory, 8(1), 21-28., ou MacKay, D. J., & Neal, R. M. (1996).

Near Shannon limit performance of low density parity check codes. Electronics letters, 32(18), 1645-1646., sont plutôt des familles dans lesquelles chaque nœud contrainte est relié à 6 nœud variable, et chaque nœud variable à exactement 3 nœuds contraintes. Ces codes sont dits codes réguliers (chaque nœud variable est lié au même nombre de nœuds contraintes, et inversement). Les codes dits réguliers sont les codes les plus utilisés, en raison de leur simplicité de mise en œuvre.

Cependant, la demanderesse a constaté expérimentalement que des codes dits irréguliers, dans lesquels les nœuds variables ne sont pas tous liés aux mêmes nombres de nœuds contraintes, présentaient une distance minimale entre les mots plus forte, et donc un probabilité de correction d'erreur plus importante. Cette constatation a également été faite par certains auteurs, par exemple dans SHORT PROTOGRAPH-BASED LDPC CODES, Dariush Divsalar, Sam Dolinar et Christopher Jones, Military Communications Conference, 2007. MILCOM 2007. IEEE, section IV.

Un code LDPC comprenant 128 nœuds variables, 64 nœuds contraintes, et pour lequel chaque nœud contrainte est lié à 7 nœuds variables permet donc avantageusement :

- De disposer d'un code de longueur courte ;
- Que chaque nœud variable soit relié à 3 nœuds contrainte ou plus. Ceci permet à la fois d'éviter la présence de nœuds variables de degré 2, et d'obtenir un code irrégulier, permettant une distance plus importante entre les mots de codes ;

Cette combinaison de caractéristiques permet donc d'obtenir des codes courts présentant des performances de décodage très élevées.

Un code LDPC selon l'invention ne possède aucun cycle de longueur 4. Ceci permet d'éviter, d'avoir des cycles très courts, ayant une probabilité élevée de propagation de croyances fausses, et permet ainsi d'augmenter de manière importante la fiabilité du code.

Un code LDPC selon l'invention permet de transmettre des données sur des canaux fortement bruités, avec un faible taux d'erreurs de décodage. Il permet ainsi d'émettre des données sur de longues distances, avec une énergie d'émission et donc une consommation électrique faible. Un code LDPC selon l'invention permet ainsi de prolonger la durée de vie d'une pile d'un compteur d'eau, de gaz ou d'électricité émettant des trames de données par liaison radio pour la télérelève, de limiter le nombre de concentrateurs de données de télérelève sur un réseau de distribution d'eau, d'électricité ou de gaz, et/ou d'augmenter le nombre de compteurs d'eau, de gaz ou d'électricité accessibles pour la télérelève.

Le code LDPC selon l'invention peut par exemple être utilisé pour transmettre des données de télérelève, particulièrement des données provenant d'un compteur d'eau ou d'énergie, par exemple de gaz ou d'électricité

L'utilisation d'un protographe permet une définition simple du graphe, tout en répartissant les arêtes de manière homogène sur l'ensemble des nœuds. Ceci permet une définition simple d'une famille de code LDPC, présentant un nombre limité de cycles courts. De plus, l'utilisation d'un protographe permet de factoriser un ensemble d'opérations de l'encodeur, et de rendre ainsi l'encodeur LDPC, et dans une moindre mesure le décodeur LDPC, moins complexe.

Avantageusement, ledit graphe bipartite de Tanner comprend, pour chaque arête entre un nœud variable du protographe et un nœud contrainte du protographe, 16 arêtes entre un nœud variable du graphe et un nœud contrainte du graphe, lesdites 16 arêtes étant définies par une permutation circulaire selon un ordre compris entre 0 et 15.

Les protographes de ce type permettent de définir le graphe de Tanner, par la simple définition, pour chaque arête du graphe, de l'ordre de permutation. La caractérisation par un protographe permet une représentation simple et compacte du graphe de Tanner du code.

Avantageusement, chaque ordre de permutation est défini par une cellule d'une matrice, chaque nœud contrainte étant représentée par une ligne de la matrice, chaque nœud variable étant représenté par une colonne de la matrice, chaque cellule de la matrice, définie sur une ligne et une colonne contenant un ordre de permutation circulaire pour une arrête entre un nœud contrainte représenté par la ligne et un nœud variable représenté par la colonne, ladite matrice (500c) étant définie par les valeurs :

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

Cette matrice définit un code LDPC possédant de très bonnes propriétés de décodage. Sa longueur minimale de code est de 14, il ne possède pas de cycle de longueur 4 , et un nombre limité de cycle de longueur 6, et possède expérimentalement d'excellentes performances de décodage et correction d'erreurs.

Par ailleurs, une distance minimale égale à 14 entre deux mots de code permet d'avoir des mots de codes aussi différents que possible les uns des autres. Ces caractéristiques permettent d'obtenir un code LDPC corrigeant le plus d'erreurs possibles.

Avantageusement, ledit graphe bipartite de Tanner comprend un nombre de cycles de longueur égale à 6 inférieur à 640.

Ceci permet de borner le nombre de cycles à un nombre faible pour un graphe de Tanner comprenant 128 nœuds variables et 64 nœuds contraintes, et donc d'obtenir un code LDPC dans lequel très peu de croyances fausses seront propagées au décodage. Cette caractéristique permet ainsi d'obtenir un code LDPC corrigeant le plus d'erreurs possibles.

Avantageusement, le code LDPC présente un taux d'erreur au décodage inférieur à 50%, lors d'une transmission affectée d'un rapport signal à bruit de -1,17 dB.

Cette caractéristique permet de limiter le taux d'erreur, dans des cas de rapport signal à bruit très faible. La possibilité de pouvoir transmettre des données avec un faible rapport signal à bruit permet d'émettre des données par un émetteur radio sur une longue distance, avec une dépense énergétique faible.

Avantageusement, l'encodeur est configuré pour encoder une trame de données comprenant des données de télérelève d'eau, de gaz ou d'électricité.

Une trame selon l'invention permet de transmettre des données télé-relevées encodées par un code de l'invention. Le code selon l'invention permet d'envoyer des données télé-relevées à grande distance avec une faible consommation énergétique.

L'invention décrit également une méthode de définition d'un code LDPC, comprenant : une étape de définition d'un ensemble de codes LDPC (Contrôle de Parité de Basse Densité) caractérisés en ce qu'ils admettent une matrice de contrôle représentée par un graphe bipartite de Tanner comprenant 128 nœuds variables du graphe et 64 nœuds contraintes du graphe, ledit graphe étant tel que : chacun des nœuds contraintes du graphe est connecté à 7 nœuds variables du graphe ; chacun des cycles du graphe a une longueur supérieure ou égale à 6 ; une étape de sélection des codes, dont la distance minimale est égale ou supérieure à un seuil prédéfini de distance minimale.

La méthode selon l'invention permet de définir une famille de codes LDPC possédant des performances élevées.

Avantageusement, la méthode comprend également une étape de sélection des codes, pour lesquels le graphe de Tanner comprend un nombre de cycles de longueur 6 inférieur à un nombre de cycles prédéfini.

Cette étape permet d'éliminer de manière rapide, parmi un grand nombre de codes, ceux qui ont des cycles de longueur 4 et qui présenteront de moins bonnes performances.

Avantageusement, la méthode comprend également une étape de sélection des codes dont le taux d'erreur est inférieur à un taux d'erreur prédéfini, lors d'une transmission affectée d'un rapport signal à bruit prédéfini.

Cette étape permet de sélectionner de manière déterministe, les codes répondant à des critères de performance précis.

Un encodeur LDPC selon l'invention permet d'encoder des trames de données qui pourront être transmises et décodées sur un canal fortement bruité. Cela permet d'envoyer les trames de données sur des liaisons radio, sur des portées longues et avec une énergie limitée.

L'invention décrit également un émetteur configuré pour émettre des trames de données comprenant des données de télérelève d'eau, de gaz ou d'électricité, encodées par un encodeur LDPC selon l'invention.

L'utilisation d'un code LDPC dans un émetteur d'un dispositif de télérelève permet, en autorisant l'envoi de données sur un canal fortement bruité, de transmettre les données sur de longues distances, avec une énergie par bit émis faible. Ceci permet de préserver la durée de vie de la pile du dispositif de télérelève.

L'invention décrit également un décodeur LDPC configuré pour décoder des signaux encodés par un code LDPC caractérisé en ce qu'il admet une matrice de contrôle représentée par un graphe bipartite de Tanner composé de 128 nœuds variables du graphe et 64 nœuds contraintes du graphe, ledit graphe étant tel que : chacun des nœuds contraintes du graphe est connecté à exactement 7 nœuds variables du graphe ; chacun des cycles du graphe a une longueur supérieure ou égale à 6 ; la distance minimale dudit code est égale ou supérieure à 14, dans lequel ledit graphe bipartite de Tanner est un graphe dérivé d'un protographe, ledit protographe comprenant 8 nœuds variables du protographe, chaque nœud variable du protographe étant un groupe de 16 nœuds variables du graphe et 4 nœuds contraintes du protographe, chaque nœud contrainte du protographe étant un groupe de 16 nœuds contraintes du graphe, dans lequel chaque nœud contrainte du protographe est relié à 7 desdits nœuds variables du protographe selon une matrice, chaque nœud contrainte étant représenté par une ligne de la matrice, chaque nœud variable étant représenté par une colonne de la matrice, chaque cellule de la matrice, définie sur une ligne et une colonne, comprenant la valeur 1 lorsque le nœud variable représenté par la ligne de la cellule et le nœud contrainte représenté par la colonne de la cellule sont reliés, et la valeur 0 dans le cas contraire, ladite matrice étant définie par les valeurs :

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

ledit décodeur LDPC étant caractérisé en ce que la distance minimale du code est égale à 14.

L'utilisation d'un code LDPC selon l'invention permet de réduire le nombre d'itérations nécessaires pour décoder le code, et ainsi la puissance de calcul nécessaire dans le décodeur. Le décodeur peut être situé dans un concentrateur de données, ou un modem lié à un concentrateur de données. Par ailleurs, l'utilisation d'un code LDPC selon l'invention permet, en autorisant le transfert de données de télérelève sur des canaux fortement bruités, d'augmenter la distance maximale entre un dispositif de comptage et un concentrateur, et ainsi de réduire le nombre de concentrateur, et/ou d'augmenter le nombre de dispositifs de comptage dont les données sont reçues.

Avantageusement, ledit graphe bipartite de Tanner comprend, pour chaque arête entre un nœud variable du protographe et un nœud contrainte du protographe, 16 arêtes entre un nœud variable du graphe et un nœud contrainte du graphe, lesdites 16 arêtes étant définies par une permutation circulaire selon un ordre compris entre 0 et 15.

Avantageusement, chaque ordre de permutation est défini par une cellule d'une matrice, chaque nœud contrainte étant représentée par une ligne de la matrice, chaque nœud variable étant représenté par une colonne de la matrice, chaque cellule de la matrice, définie sur une ligne et une colonne contenant un ordre de permutation circulaire pour une arrête entre un nœud contrainte représenté par la ligne et un nœud variable représenté par la colonne, ladite matrice étant définie par les valeurs :

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

Avantageusement, ledit graphe bipartite de Tanner comprend un nombre de cycles de longueur égale à 6 inférieur à 640.

Avantageusement, le code présente un taux d'erreur au décodage inférieur à 50%, lors d'une transmission affectée d'un rapport signal à bruit de -1,17 dB.

Avantageusement, le décodeur est configuré pour décoder une trame de données comprenant des données de télérelève d'eau, de gaz ou d'électricité.

L'invention décrit également un récepteur configuré pour recevoir des trames de données comprenant des données de télérelève d'eau, de gaz ou d'électricité, encodées par un encodeur LDPC selon l'invention, ledit récepteur comprenant un décodeur selon l'invention.

Le récepteur peut être un modem comprenant antenne, radioélectrique, ledit modem étant lié à un concentrateur.

LISTE DES FIGURES

D'autres caractéristiques apparaîtront à la lecture de la description détaillée donnée à titre d'exemple et non limitative qui suit, faite au regard de dessins annexés qui représentent:

- la figure 1, une architecture d'un réseau de collecte et de concentration de mesures de senseurs d'un réseau de distribution dans un mode de réalisation de l'invention;
- la figure 2, une architecture physique d'un concentrateur de données dans un mode de réalisation de l'invention;
- la figure 3, une trame de message pour la transmission de données de télérelève d'un réseau de distribution d'eau dans un mode de réalisation de l'invention;

- les figures 4a et 4b, respectivement un exemple de protographe, et un exemple de permutation permettant d'obtenir un graphe bipartite de Tanner à partir d'un protographe dans un mode de réalisation de l'invention;
- les figures 5a, 5b et 5c, respectivement la structure d'un code LDPC selon l'invention, un ensemble de contraintes sur un code LDPC selon l'invention, permettant de s'assurer qu'il ne comprend aucun cycle de longueur 4, et un exemple de code LDPC selon l'invention;
- les figures 6a et 6b, deux méthodes de définition d'un code LDPC selon l'invention ;
- les figures 7a et 7b, une comparaison de performances entre un code LDPC selon l'invention et un code LDPC de l'art antérieur, respectivement suivant une échelle linéaire et une échelle logarithmique ;
- les figures 8a et 8b, des exemples de nombre d'itérations nécessaires pour décoder Code LDPC selon l'invention, respectivement à mauvais et à bon SNR.

## DESCRIPTION DETAILLEE

Dans la suite de la description les code LDPC, encodeur, décodeur et procédé selon l'invention sont illustrés par des exemples relatifs à la télérelève, notamment de données relatives à la consommation d'eau. Cependant, un Code LDPC selon l'invention est applicable à la transmission de tout type de données.

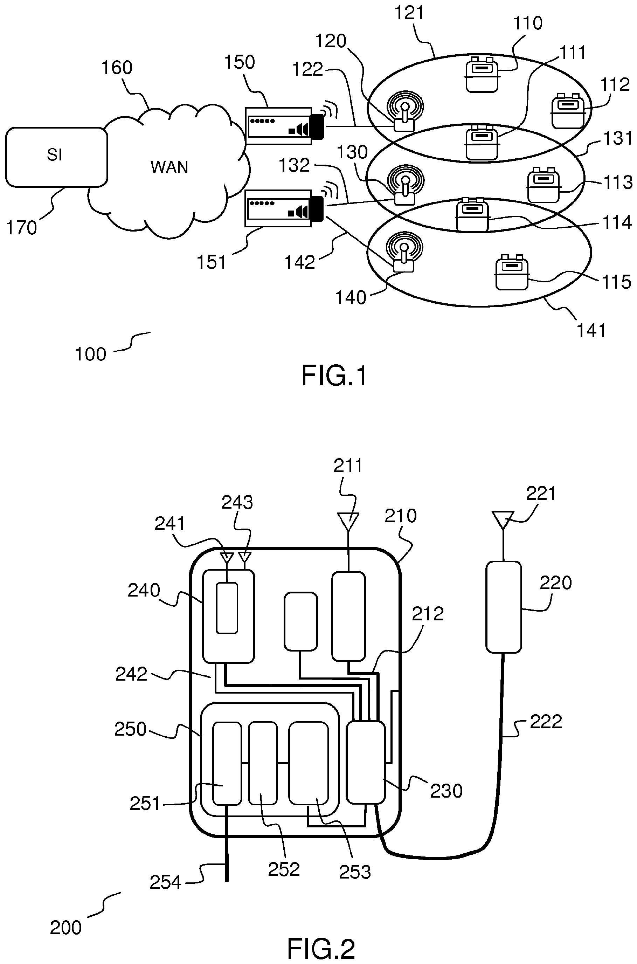

La figure 1 représente une architecture d'un réseau de collecte et de concentration de mesures de senseurs d'un réseau de distribution dans un mode de réalisation de l'invention.

L'architecture 100 est formée de :

- Un ensemble de dispositifs de comptage. 6 dispositifs de comptage 110, 111, 112, 113, 114, 115 sont représentés en figure 1 ;
- Des modems LAN (de l'anglais Local Area Network, ou Réseau Zone Locale) 120, 130, 140 ;
- Des concentrateurs 150, 151 ;
- Un réseau WAN (de l'acronyme anglais Wide Area Network, ou Réseau Ethernet) 160 ;
- Un Système d'Information (SI) 170.

Les dispositifs de comptage 110, 111, 112, 113, 114, 115 peuvent être des compteurs d'eau, mais aussi des compteurs de gaz, électricité, ou de tout type de consommation. Les dispositifs de comptage envoient les données de comptage, ou données de télérelève, par ondes radio. La transmission des données par ondes radio permet d'envoyer les données à distance, même si le dispositif de comptage est isolé ou dans un endroit peu accessible. De plus, l'envoi de données par ondes radio permet de déployer de nouveaux compteurs de manière beaucoup plus aisée et économique, que si une liaison filaire était nécessaire. Les dispositifs de comptage 110, 111, 112, 113, 114, 115 sont généralement alimentés par une pile. L'utilisation d'une liaison radio pour transmettre les données localement à un modem LAN permet aux dispositifs de comptage de pouvoir transmettre leurs données avec une consommation électrique faible, donc en préservant la durée de vie de la pile.

Afin de transmettre les données de télérelève, les dispositifs de comptage sont équipés d'un encodeur LDPC configuré pour encoder des signaux en utilisant un code LDPC admettant une matrice de contrôle représentée par un graphe bipartite de Tanner comprenant 128 nœuds variables du graphe et 64 nœuds contraintes du graphe, ledit code étant caractérisé en ce que : chacun des nœuds contraintes du graphe est connecté à 7 nœuds variables du graphe ; chacun des cycles du graphe a une longueur supérieure ou égale à 6 ; la distance minimale dudit code est égale ou supérieure à un seuil prédéfini de distance minimale. Les différents modes de réalisation dudit code LDPC sont décrits en référence aux figures suivantes. Cet encodeur peut être implémenté sous forme matérielle ou logicielle. Par exemple, il peut être présent sous forme d'instructions de codes permettant de configurer un processeur pour décoder un code LDPC selon l'invention. Dans un autre mode de réalisation de l'invention, il peut s'agir d'une logique de calcul électronique. L'utilisation d'un encodeur LDPC selon l'invention permet d'émettre les trames de données de télérelève avec une énergie faible, et ainsi de préserver la durée de vie de la pile.

Les données de télérelève forment, après application du code LDPC, une trame de données encodées. Afin de transmettre lesdites trames de données, les dispositifs de comptage sont équipés d'au moins émetteur configuré pour émettre des trames de données comprenant des données de télérelève d'eau, de gaz ou d'électricité, encodées par un encodeur LDPC selon l'invention. L'émetteur de données peut être par exemple un modem intégré au dispositif de comptage, comprenant un modulateur et une antenne radio. Selon différents mode de réalisation de l'invention, la modulation peut par exemple être du type GMSK (de l'anglais Gauss Minimum Shift Keying, ou Modulation à Déplacement Minimum Gaussien) ou GFSK (de l'anglais Gaussian Frequency Shift Keying ou Modulation par Déplacement de Fréquence Gaussienne). L'invention peut également être appliquée à d'autres types de modulation, telles que les modulations BPSK (de l'anglais Binary Phase Shift Keying, ou Modulation à Déplacement de Phase Binaire), QPSK (de l'anglais Quadrature Phase Shift Keying, ou Modulation de Phase à Quadrature), OQPSK (de l'anglais Offset Quadrature Phase Shift Keying, ou Modulation de Phase à Quadrature à Offset), etc...

Les modems LAN 120, 130, 140 sont configurés pour recevoir des données des dispositifs de comptage 110, 11, 112, 113, 114, 115 par liaison radio. Chacun des modems LAN 120, 130, 140 est capable de recevoir des données de dispositifs de comptages situées dans sa zone de couverture radioélectrique. Les zones de couvertures radioélectriques de 3 modems 120, 130, 140 sont respectivement les zones 121, 131, 141. Par exemple, le dispositif de comptage 110 est situé dans la zone de couverture radioélectrique 121 : les données envoyées par le dispositif de comptage 110 seront donc reçues par le modem LAN 120. Le dispositif de comptage 111 est lui situé à la fois dans la zone de couverture radioélectrique 121 et dans la zone de couverture radioélectrique 131. Les données envoyées par le dispositif de comptage 111 seront donc reçues à la fois par le modem LAN 120 et le modem LAN 130. Selon différents modes de réalisation de l'invention, les liaisons entre les dispositifs de comptage et les modems peuvent être des liaisons unidirectionnelles ou des liaisons bidirectionnelles. Dans le cas d'une liaison unidirectionnelle, le dispositif de comptage peut envoyer périodiquement une donnée de consommation. Dans le cas d'une liaison bidirectionnelle, une donnée de consommation peut être envoyée en réponse à un message d'un modem 120, 130 ou 140. Dans d'autres modes de réalisation de l'invention, les modems 120, 130, 140 sont mobiles.

L'utilisation d'un code LDPC selon l'invention permet, en autorisant la transmission sur un canal fortement bruité, d'augmenter la portée de la transmission de données de télérelève. Ainsi, les zones de couverture radioélectrique s'en trouvent agrandies. Ceci permet en même temps de réduire le nombre de concentrateurs/modems pour couvrir un même nombre de dispositifs de comptage, et/ou d'augmenter le nombre de dispositifs de comptage dont les signaux sont perçus. L'utilisation d'un code LDPC selon l'invention permet ainsi la télérelève sur des dispositifs de comptage très peu accessibles, par exemple des dispositifs de comptage sur des sites profondément enfouis.

Les modems LAN 120, 130, 140 sont liés aux concentrateurs 150, 151 par l'intermédiaire de liaisons Ethernet, respectivement les liaisons 122, 132 et 142.

Les concentrateurs 150, 151 envoient les données issues des dispositifs de comptage au SI 170 par l'intermédiaire d'un réseau WAN 160. Le réseau WAN 160 peut par exemple être un réseau 2G ou 3G. Le système d'information 170 peut ainsi récupérer l'ensemble des données issues des dispositifs de comptage, et de réaliser efficacement la télérelève de consommations. Ces données pourront ainsi être utilisées pour calculer les consommations des différents utilisateurs. Selon d'autres modes de mise en œuvre de l'invention, les données issues des dispositifs de comptage peuvent également être utilisées pour améliorer la détection d'événements sur un réseau de distribution. Par exemple, dans un mode de réalisation dans lequel les dispositifs de comptage sont des dispositifs de comptage d'une consommation sur un réseau de distribution d'eau, les données de consommation pourront être utilisées pour détecter des fuites dans le réseau de distribution d'eau. Les demandes de brevet européen n°15306029.8, et n°15306546.1, déposées par le demandeur, décrivent chacune une méthode de détection d'événement dans un réseau de distribution d'eau, dans lesquelles des données capteurs, pouvant comprendre des données issues de la télérelève, sont utilisées pour détecter des événements, par exemple des fuites, dans un réseau de distribution d'eau.

L'architecture 100 est décrite à titre d'exemple non-limitatif uniquement. Un homme de l'art peut imaginer d'autres architectures, comprenant notamment un nombre plus ou moins élevé de dispositifs de comptage, concentrateurs, et/ou modems LAN.

La figure 2 représente une architecture physique d'un concentrateur de données dans un mode de réalisation de l'invention.

Le concentrateur 200 comprend au moins un récepteur, qui peut être un modem LAN. Il peut s'agir d'un modem LAN interne 210 et/ou d'un modem LAN externe 220. Le modem LAN peut comprendre une antenne 211, 221 pour recevoir des données des dispositifs de comptage, et est lié à une carte de brassage 230 par le biais d'une liaison Ethernet 212, 222. La liaison Ethernet 221, 222 peut être utilisée à la fois pour la transmission des données et l'alimentation du modem. Dans le cas d'un modem externe, la liaison Ethernet filaire peut avoir une longueur limitée, par exemple à 100m.

Dans un mode de réalisation de l'invention, la liaison radioélectrique entre les dispositifs de comptage et le récepteur 211, 221 utilise un protocole basé sur la norme EN13757-4, et peut par exemple utiliser une bande de réception de +/-50 KHz autour de la fréquence centrale, qui peut par exemple être 169.45 MHz. Le modem LAN 210, 211 peut alors être configuré pour filtrer simultanément 6 canaux de largeur 12,5 kHz. Le modem LAN 210, 211 comprend au moins un démodulateur. Tout type de modulation peut être utilisé dans l'invention. Dans des modes de mise en œuvre de l'invention, le démodulateur peut par exemple être configuré pour démoduler chacun des canaux à l'aide de l'un des démodulateurs suivants :

• Un démodulateur GFSK (de l'acronyme anglais Gaussian Frequency-Shift Keying, ou Modulation par Déplacement de Fréquence Gaussien) compatible avec un mode de transmission à 2400bps (bits par seconde) ;
• Un démodulateur GFSK compatible avec le mode de transmission N/2400 bps de la norme pr-EN13757-4 ;
• Un démodulateur GFSK compatible avec le mode N/4800bps de la norme pr-EN13757-4 ;
• Un démodulateur 4GFSK compatible avec le mode WM-HSPEED (6400bps) ;
• Un démodulateur GMSK d'ordre ½, la modulation GMSK d'ordre ½ se montant particulièrement efficace pour la transmission de codes LDPC.

Le modem 210, 220 comprend également un décodeur LDPC selon l'invention. Ce décodeur peut être implémenté sous forme matérielle ou logicielle. Par exemple, il peut être présent sous forme d'instructions de codes permettant de configurer un processeur pour décoder un code LDPC selon l'invention. Dans un autre mode de réalisation de l'invention, il peut s'agir d'une logique de calcul électronique.

La présence d'un décodeur LDPC selon l'invention permet au modem 210, 220 de décoder des signaux transmis sur un canal fortement bruité. Ainsi, des trames de télérelève émises par un dispositif de comptage lointain ou enfoui et/ou émises avec une faible puissance pourront, même si certains bits ont été altérés pendant la transmission, être correctement décodées. La zone de couverture radioélectrique du modem 210, 220 s'en trouve accrue. Il est alors possible de diminuer le nombre de concentrateurs et/ou de recevoir des trames de dispositif de comptages plus lointains ou moins accessibles. L'efficacité opérationnelle de la télérelève s'en trouve accrue.

La carte de brassage 230 est elle-même liée par le biais d'une liaison Ethernet 242 à un modem WAN. Le modem WAN permet l'envoi de données à un SI (Système d'Information). Par exemple, le modem WAN 240 peut permettre l'envoi de données au SI 170 par le biais du réseau WAN 160. Selon différents modes de réalisation de l'invention, le modem WAN 240 peut être un modem 2G si le réseau WAN est un réseau 2G, un modem 3G si le réseau WAN est un réseau 32G, etc... Le modem WAN est équipé d'une antenne WAN 241 adapté au type de réseau WAN considéré. Dans un mode de réalisation de l'invention, le modem WAN 240 est également équipé d'un récepteur GPS 243.

Le concentrateur 200 est alimenté par un bloc alimentation 250. Le bloc alimentation 250 comprend un disjoncteur, un parasurtenseur 252, et un convertisseur AC/DC 253, et est alimenté par une arrivée alimentation secteur 254.

Le concentrateur 200 peut ainsi recevoir, via les modems LAN 210, 220, les messages émis par les dispositifs de comptage situés dans les zones de couverture radioélectriques des modems LAN 210, 220, puis les transmettre, via le modem WAN 240, à un SI, par exemple le SI 170. L'architecture du concentrateur de données 200 permet ainsi de transmettre, à un SI distant, des messages émis localement par les dispositifs de comptage.

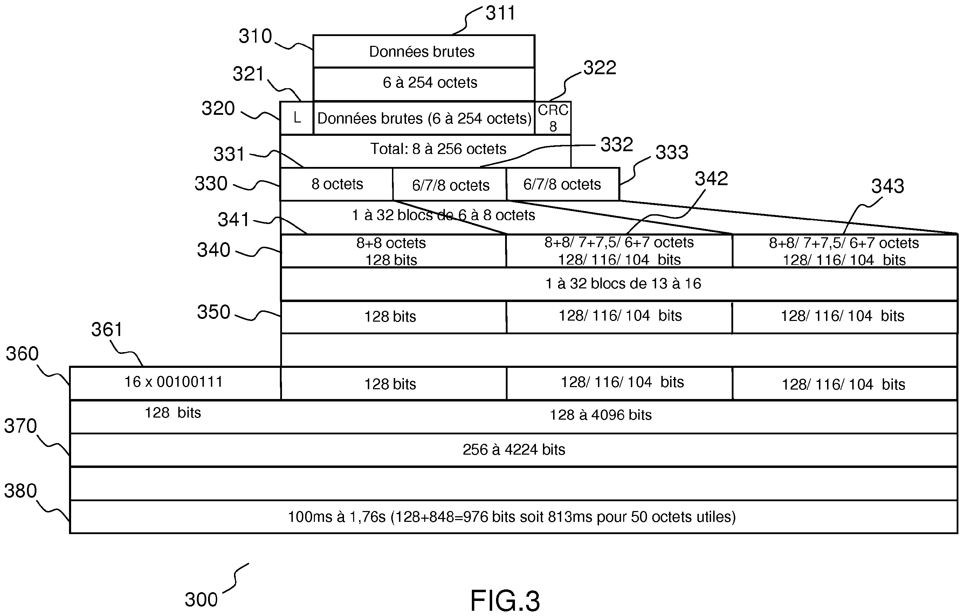

La figure 3 représente une trame de message pour la transmission de données de télérelève d'un réseau de distribution d'eau dans un mode de réalisation de l'invention.

La trame de message 300 sera représentée selon les étapes successives de sa formation, depuis les données brutes jusqu'à la trame modulée.

La trame de message 300 selon l'invention peut contenir tout type de données. Dans un mode de réalisation de l'invention, elle comprend des données de télérelève d'eau ou d'énergie, par exemple de gaz ou d'électricité.

Une première étape 310 consiste à récupérer des données brutes 311. Les données brutes 311 contiennent par exemple des données de télérelève de consommation d'eau ou d'énergie. Les données de télérelève peuvent par exemple contenir une consommation journalière. Dans un mode de réalisation, les données brutes comprennent entre 6 et 254 octets.

Une seconde étape 320 consiste à ajouter avant les données brutes 311 un en-tête 321 contenant un champ longueur indiquant la longueur de la trame, et ajouter après les données brutes un octet CRC (de l'anglais Cyclic Redundancy Check, ou Contrôle de Redondance Cyclique) 322. L'octet CRC permet de détecter des erreurs de transmission au sein des données brutes. Dans un mode de réalisation de l'invention, le champ de longueur 321 est codé sur un octet, et la trame à l'issue de la seconde étape 320 a une longueur comprise entre 8 et 256 octets.

Une troisième étape 330 consiste à séparer la trame en blocs 331, 332, 333. Dans un mode de réalisation de l'invention, la taille de chaque bloc est comprise entre 6 et 8 octets, la répartition des tailles de blocs étant fonction de la taille de la trame. L'utilisation de blocs de 6 à 8 octets permet d'obtenir des blocs d'une taille suffisante pour bénéficier d'un codage LDPC efficace. La trame 300 comprend trois blocs 331, 332, 333. Cependant, dans d'autres modes de réalisation de l'invention, une trame selon l'invention peut comprendre plus ou moins de blocs.

Une quatrième étape 340 consiste à appliquer à chaque bloc un codage LDPC. A l'issue de cette étape, la trame contient des blocs 341, 342, 343 comprenant des octets de redondance codés selon un code LDPC de l'invention.

Une cinquième étape 350 consiste à appliquer aux blocs une séquence de dispersion pseudo aléatoire. Cette séquence de dispersion pseudo aléatoire permet d'obtenir une densité moyenne de transitions dépendant peu de la trame transmise. Dans un mode de réalisation de l'invention, la séquence de dispersion est définie de la manière suivante :

- La trame codée est définie par une séquence de N bits $\{c_0... c_{N-1}\}$ ;
- La trame codée est transformée en une suite de N symboles $\{m_0...m_{N-1}\}$ par l'application d'un opérateur OU exclusif binaire avec une séquence de dispersion dk par l'opération suivante : $m_k = c_k \oplus d_k$, dans laquelle l'opérateur $\oplus$ représente le OU exclusif binaire entre les bits de l'opérande de gauche et les bits de l'opérande de droite ;
- La séquence est définie de manière itérative :

  ○ Les douze valeurs initiales sont $\{d_0 d_1 d_2...d_{11}\}$ = {101110010101} ;
  ○ Les valeurs ultérieures sont définies par : $d_k = d_{k-2} \oplus d_{k-10} \oplus d_{k-11} \oplus d_{k-12}$

Une sixième étape 360 consiste à ajouter un en-tête 361 à la trame. Cet en-tête 361 prédéfini permet à un récepteur d'identifier les trames de données de l'invention.

Une septième étape 370 consiste à appliquer un codage différentiel à la trame.

Une huitième étape 380 consiste à appliquer une modulation à la trame après codage différentiel. Dans un mode de réalisation de l'invention, la modulation de la trame est du type GMSK.

La trame 300 est donnée à titre d'exemple uniquement, de nombreux autres formats de trame pourront être développés par l'homme de l'art. Par exemple, l'homme de l'art pourra sélectionner des tailles de blocs différentes, sélectionner une séquence de dispersion différente, ne pas appliquer de séquence de dispersion, ou appliquer un autre type de modulation.

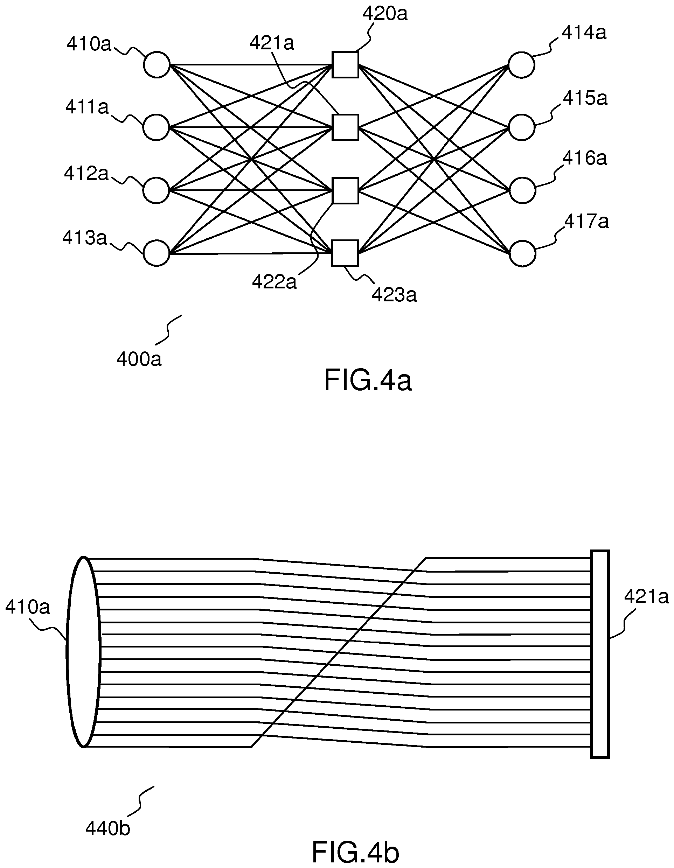

Les figures 4a et 4b représentent respectivement un exemple de protographe et un exemple de permutation permettant d'obtenir un graphe bipartite de Tanner à partir d'un protographe dans un mode de réalisation de l'invention.

La figure 4a représente un protographe dans un mode de réalisation de l'invention. Dans un ensemble de modes de réalisation de l'invention, le graphe bipartite est dérivé d'un protographe, par exemple le protographe 400a représenté en figure 4a. Les protographes permettent de construire, de manière simple et efficace, des graphes de Tanner. L'utilisation de protographes est notamment décrite par Thorpe, J. (2003). Low-density parity-check (LDPC) codes constructed from protographs. IPN progress report, 42(154), 42-154.

Un code LDPC selon l'invention admet une matrice de contrôle représentée par un graphe bipartite de Tanner comprenant 128 nœuds variables du graphe et 64 nœuds variables du graphe. Le graphe de Tanner est remarquable en ce que chacun des nœuds contraintes du graphe est connecté à 7 nœuds variables du graphe.

De plus, ledit graphe bipartite de Tanner ne comprend aucun cycle de longueur inférieure à 6, ce qui permet d'augmenter encore les performances d'un code LDPC selon l'invention. En effet, la présence de cycles de longueur courte dans un graphe de Tanner augmente la probabilité, au décodage, d'avoir une propagation de croyances incorrecte, et donc de ne pas détecter, ou propager une erreur. L'absence de cycle de longueur 4 dans un graphe selon l'invention permet donc de supprimer les cas de propagation d'erreur les plus critiques, et d'augmenter les performances du code LDPC selon l'invention.

Dans un mode de réalisation de l'invention, le nombre de cycles de longueur 6 du graphe de Tanner est par ailleurs inférieur à un nombre de cycles prédéfini. Bien que la présence de cycles de longueur 6 dans le graphe soit moins critique que la présence de cycles de longueur 4, il est souhaitable de limiter leur présence afin de limiter le nombre de cycles pour lesquels une croyance fausse peut être propagée. Dans un mode de réalisation de l'invention, le nombre de cycles de longueur 6 d'un graphe bipartite de Tanner est inférieur à 640. Cette valeur permet d'obtenir une famille de codes LDPC suffisamment large pour contenir des codes performants, tout en supprimant de facto des codes ayant un nombre de cycles de longueur 6 plus important, et ayant donc de manière générale des performances plus faibles.

De plus, la distance minimale ou distance de Hamming d'un code LDPC selon l'invention est supérieure ou égale à un seuil prédéfini. Cette caractéristique permet d'augmenter encore les performances d'un code LDPC selon l'invention, en s'assurant que les mots de code sont suffisamment différents les uns des autres. Dans un mode de réalisation de l'invention, la distance minimale d'un code LDPC selon l'invention est 14.

Dans un ensemble de modes de réalisation de l'invention, un code LDPC selon l'invention présente un taux d'erreur inférieur à un taux d'erreur prédéfini, lors d'une transmission affectée d'un rapport signal à bruit prédéfini. Cette caractéristique peut être vérifiée de manière expérimentale, en codant des messages et en simulant une transmission avec un rapport signal à bruit donné. Dans un mode de réalisation de l'invention, le taux d'erreur est inférieur à 50%, lors d'une transmission affectée d'un rapport signal à bruit de -1,17 dB.

Le protographe 400a comprend 8 nœuds variables du protographe 410a, 411a, 412a, 413a, 414a, 415a, 416a et 417a. Les nœuds variables du protographe 410a, 411a, 412a et 413a comprennent les bits utiles du message à transmettre, alors que les nœuds variables 414a, 415a, 416a, 417a du protographe comprennent les bits de redondance. Chaque nœud variable du protographe est un groupe de 16 nœuds variables du graphe. Le protographe 400a comprend également 4 nœuds contraintes 420a, 421a, 422a et 423a. Chacun des nœuds contraintes du protographe est relié à 7 nœuds variables du protographe. Les lignes sur la figure 4a représentent les liaisons entre les nœuds. Par exemple, le nœud contrainte 420a est relié aux 7 nœuds variables 410a, 411a, 412a, 413a, 415a, 416a et 417a.

De manière équivalente, le protographe peut être représenté par une matrice chaque nœud contrainte étant représentée par une ligne de la matrice, chaque nœud variable étant représenté par une colonne de la matrice, chaque cellule de la matrice, définie sur une ligne et une colonne, comprenant la valeur 1 lorsque le nœud variable représenté par la ligne de la cellule et le nœud contrainte représenté par la colonne de la cellule sont reliés, et la valeur 0 dans le cas contraire, ladite matrice étant définie par les valeurs. Le protographe de la figure 4a serait ainsi représenté par la matrice :

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

La figure 4b représente un exemple de permutation circulaire d'ordre 1 permettant d'obtenir un graphe bipartite de Tanner à partir d'un protographe dans un mode de réalisation de l'invention.

La permutation 440b représentée en figure 4b représente une permutation appliquée aux liaisons entre le groupe de 16 nœuds variables du graphe associé au nœud variable du protographe 410a, et le groupe de 16 nœuds contraintes du graphe associés au nœud contrainte du protographe 421a. Des permutations similaires sont applicables à toutes les transitions représentées en figure 4a. Les nœuds variables et contraintes du graphe sont alignés selon leur ordre dans le groupe de nœuds variables ou de nœuds contraintes. Dans l'exemple illustré, la permutation est de 1: si l'on considère que chaque nœud variable ou contrainte du graphe est affecté d'un ordre i compris entre 0 et 15 représentant sa position dans le groupe de nœuds, chaque nœud variable, d'ordre i, est relié au nœud contrainte d'ordre i+1, à l'exception du nœud variable d'ordre 15, qui est relié au nœud variable d'ordre 0.

De manière plus générale, dans un mode de réalisation de l'invention, lorsqu'un nœud variable du protographe est relié à un nœud contrainte du protographe, la permutation permettant d'obtenir les liaisons entre les nœuds variables du graphe et les nœuds contraintes du graphe associés est défini par un unique ordre n de permutation compris entre 0 et 15. Selon la notation définie plus haut, le nœud variable du graphe d'ordre i du groupe de nœuds variables du graphe est relié au nœud contrainte d'ordre $(i + n) \mod 16$. Dans un autre mode de réalisation de l'invention, le nœud variable du graphe d'ordre i du groupe de nœuds variables du graphe est relié au nœud contrainte d'ordre $(i - n) \mod 16$. Dans un autre mode de réalisation de l'invention, l'une de ces deux possibilités est utilisée pour les liaisons avec les nœuds variables représentatifs de bits utiles, et l'autre pour les liaisons avec les nœuds variables représentatifs de bits de redondance. Dans la suite de la description, chacune des deux possibilités (relier le nœud variable d'ordre i au nœud contrainte d'ordre $(i + n) \mod 16$ ; relier le nœud variable d'ordre i au nœud contrainte d'ordre $(i - n) \mod 16$) sera définie comme une convention de permutation, les deux conventions de permutation étant respectivement notées « convention de permutation $(i + n) \mod 16$ » et « convention de permutation $(i - n) \mod 16$ ) ».

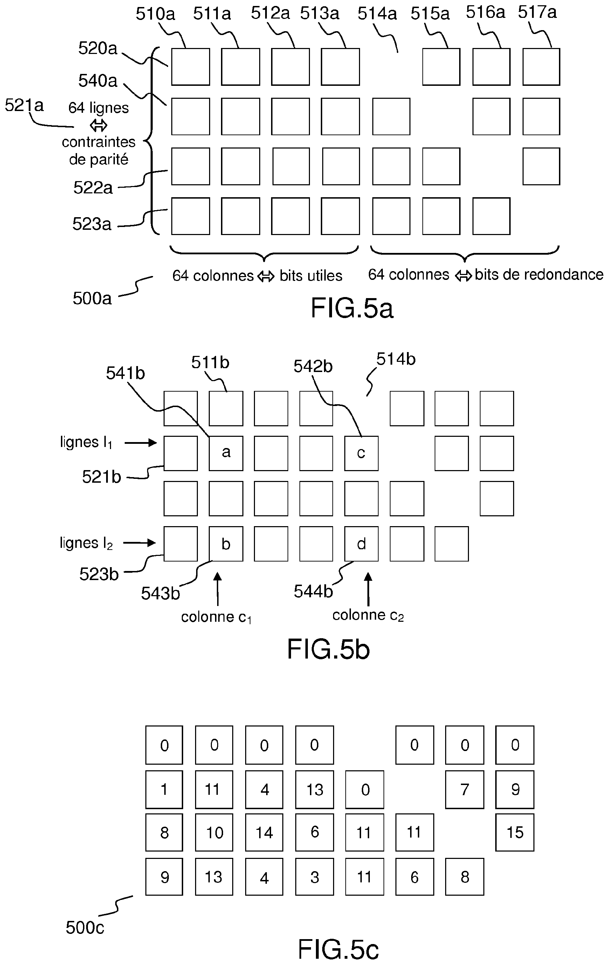

Les figures 5a, 5b et 5c représentent respectivement la structure d'un code LDPC selon l'invention, un ensemble de contraintes sur un code LDPC selon l'invention, permettant de s'assurer qu'il ne comprend aucun cycle de longueur 4, et un exemple de code LDPC selon l'invention.

La figure 5a représente la structure d'un code LDPC selon l'invention.

Un code LDPC selon l'invention peut être défini par la matrice 500a. Chacune des cellules de la matrice 500a stocke un ordre de permutation, tel que défini par exemple par la permutation 400b.

Les 4 lignes 520a, 521a, 522a, 523a représentent respectivement les 4 nœuds contraintes du protographe 420a, 421a, 422a, 423a. Les 4 colonnes 510a, 511a, 512a, 513a représentent respectivement les 4 nœuds variables du protographe associés à des bits utiles 410a, 411a, 412a, 413a. Les 4 colonnes 514a, 515a, 516a, 517a représentent respectivement les 4 nœuds variables du protographe associés à des bits de redondance 414a, 415a, 416a, 417a. Ainsi, la cellule 540a contient-elle par exemple l'ordre de permutation de la liaison entre le nœud variable du protographe 410a (première colonne) et le nœud contrainte du protographe 421a (deuxième ligne).

La structure de la matrice 500a reflète bien la structure du protographe 400a : chaque nœud contrainte du protographe est lié aux 4 nœuds variables du protographe représentant des bits utiles, et à 3 nœuds variables du protographe représentant des bits de redondance, soit 7 noeuds variables du protographe en tout. Par ailleurs, l'absence de cellule comprenant un ordre de permutation entre les colonnes et lignes 520a et 514; 521a et 515a ; 522a et 516a ; 523a et 517a correspondent respectivement aux absences de liaisons entre les nœuds 420a et 414a ; 421a et 415a ; 422a et 416a ; 423a et 417a respectivement.

L'ensemble des ordres de permutation contenus dans les cellules de la matrice 500a permet donc bien de définir le graphe de Tanner de manière déterministe : l'application de l'ordre de permutation de chaque cellule aux groupes de 16 nœuds variables et de 16 nœuds contraintes du graphe correspondant permet de générer toutes les liaisons entre nœuds contraintes et nœuds variables du graphe. Dans un mode de réalisation de l'invention, ces liaisons sont exprimées sons la forme d'une matrice de liaisons dérivée de la matrice 500a, chaque ligne de la matrice 500a étant scindée en 16, chaque colonne de la matrice 500a étant également scindée en 16, et les liaisons ou absences de liaisons entre nœuds contraintes et nœuds variables du graphe étant matérialisés respectivement par des « 1 » et des « 0 » dans la matrice de contrôle.

La figure 5b représente un ensemble de contraintes sur un code LDPC selon l'invention, permettant de s'assurer qu'il ne comprend aucun cycle de longueur 4.

La structure bipartite du graphe de Tanner engendre les deux propriétés suivantes : un cycle dans le graphe a nécessairement une longueur paire, supérieure ou égale à 4. Par ailleurs, un cycle de longueur 4 n'est obtenu que si deux nœuds contraintes du graphe sont reliés à un même nœud variable du graphe représentatif d'un bit utile, et à un même nœud variable du graphe représentatif d'un bit de redondance. Dans les modes de réalisations de l'invention dans lesquels le graphe de Tanner est obtenu par un protographe tel que le protographe 400a, et par des permutations telles que la permutation 400b, un cycle de longueur 4 est obtenu si, pour deux lignes $l_1$ et $l_2$ différentes parmi les lignes 520a, 521a, 522a, 523a, une colonne $c_1$ parmi les colonnes 510a, 511a, 512a, 513a, et une seconde colonne $c_2$ parmi les colonnes 514a, 515a, 516a et 517a, le valeurs des ordres de permutation $i\{c_1, l_1\}$, $i\{c_1, l_2\}$, $i\{c_2, l_1\}$ et $i\{c_2, l_2\}$ contenus respectivement dans les cellules de coordonnées $i\{c_1, l_1\}$, $i\{c_1, l_2\}$, $i\{c_2, l_1\}$ et $i\{c_2, l_2\}$ de la matrice sont telles que :

- $(i\{c_1, l_1\} - i\{c_2, l_1\})$ mod 16 = $(i\{c_1, l_2\} - i\{c_2, l_2\})$ mod 16, si les liaisons avec les nœuds variables représentatifs de bits utiles sont affectées de la même convention de permutation que les nœuds variables représentatifs de bits de redondance ;
- $(i\{c_1, l_1\} + i\{c_2, l_1\})$ mod 16 = $(i\{c_1, l_2\} + i\{c_2, l_2\})$ mod 16, si les liaisons avec les nœuds variables représentatifs de bits utiles et les nœuds variables représentatifs de bits de redondance sont affectées de conventions de permutation différentes;

La figure 500b présente un exemple de détection de cycle de longueur 4. Dans cet exemple, une détection de cycles de longueur 4 sera opérée sur les cellules 541b, 542b, 543b et 544b. Les cellules 541b et 542b sont situées sur la ligne 521b, les cellules 543b et 544b sur la ligne 523b, les cellules 541b et 543b sur la colonne 511b, et les cellules 542b et 544b sur la ligne 514b. Les quatre cellules contiennent donc les ordres de permutation suivants :

- La cellule 541b un ordre a, représentatif de la permutation affectée à la liaison entre les nœuds 411a et 421a du protographe 400a ;
- la cellule 542b un ordre c, représentatif de la permutation affectée à la liaison entre les nœuds 414a et 421a du protographe 400a ;
- la cellule 543b un ordre c, représentatif de la permutation affectée à la liaison entre les nœuds 411a et 423a du protographe 400a ;
- la cellule 544b un ordre d, représentatif de la permutation affectée à la liaison entre les nœuds 414a et 423a du protographe 400a .

On supposera dans cet exemple qu'une permutation selon la convention $(i + n)$ mod 16 est affectée à l'ensemble des liaisons du protographe, qu'il s'agisse de liaisons avec des nœuds variables représentatifs de bits utiles ou de liaisons avec des nœuds variables représentatifs de bits de redondance. Un homme de l'art pourra aisément adapter ces conditions, si d'autres conventions de permutations étaient utilisées.

Si la condition (a-c) mod 16 = (b-d) mod 16 est vérifiée, cela signifie qu'un nœud variable d'ordre i, au sein du groupe de 16 nœuds variables du graphe associé au nœud variable 411a du protographe est connecté à un nœud variable d'ordre (i+a-c) mod 16 dans le groupe de 16 nœuds variables du graphe associé au nœud variables 414b du protographe par l'intermédiaire de deux arêtes passant par un des nœuds contraintes 521b.

Cependant, ce même nœud variable d'ordre i est également relié par deux arêtes passant par un des nœuds contraintes 523b, au nœud variable d'ordre (i+b-d) mod 16 dans le groupe de 16 nœuds variables du graphe associé au nœud variable 414b du protographe. Si la condition (a-c) mod 16 = (b-d) mod 16 est vérifiée, les nœuds d'ordre (i+a-c) mod 16 et d'ordre (i+b-d) mod 16 sont donc identiques : les deux nœuds sont reliés par deux groupes de deux arêtes distincts, et un cycle de longueur 4 est formé.

Un cycle de longueur 4 ne peut être formé que par deux groupes d'arêtes reliant un nœud variable représentatif d'un bit utile et un nœud variable représentatif d'un bit de redondance, et passant par deux nœuds contraintes différents. L'absence de cycle de longueur 4 dans un graphe peut ainsi être démontrée, si aucun groupe de 4 ordres disposés sur deux lignes et deux colonnes (une des colonnes correspondant un nœud du protographe représentatif de bits utiles, et l'autre correspondant à un nœud du protographe représentatif de bits de redondance) ne vérifie pas l'une des conditions exposées ci-dessus.

La figure 5c représente un exemple de code LDPC selon l'invention.

La matrice 500c, définit, par le biais d'ordres de permutation selon la convention de la matrice 500a, un graphe de Tanner définissant un code LDPC selon l'invention. La matrice de contrôle 500c est représentée par un graphe de Tanner ne présentant aucun cycle de longueur 4, 544 cycles de longueur 6, une distance minimale entre deux mots de codes égale à 14. Le code LDPC admettant cette matrice de contrôle présente des performances particulièrement élevées.

Il est à noter en effet que cette matrice possède des propriétés intéressantes. La distance minimale du code est de 14, pour un code de longueur 128. Le ratio distance minimale / longueur de code de cette matrice est donc 0,1094. Les ratios distance minimale / longueur de code typiques sont par exemple divulguées par SHORT PROTOGRAPH-BASED LDPC CODES, Dariush Divsalar, Sam Dolinar et Christopher Jones, Military Communications Conference, 2007. MILCOM 2007. IEEE, section IV. Un ratio typique pour un code régulier (3,6) est ainsi de 0,023, alors qu'un ratio typique pour un code aléatoire est de 0,11. On constate donc que le ratio distance minimale / longueur de code de cette famille est très élevé (proche de celle d'un code aléatoire, et largement supérieure à celle d'un code régulier (3,6) classique). Ceci permet à un code LDPC selon l'invention de posséder de bonnes performances de décodage. Cependant, un code selon l'invention est plus structuré qu'un code aléatoire, ce qui lui permet d'être beaucoup plus simple à encoder et décoder qu'un code aléatoire.

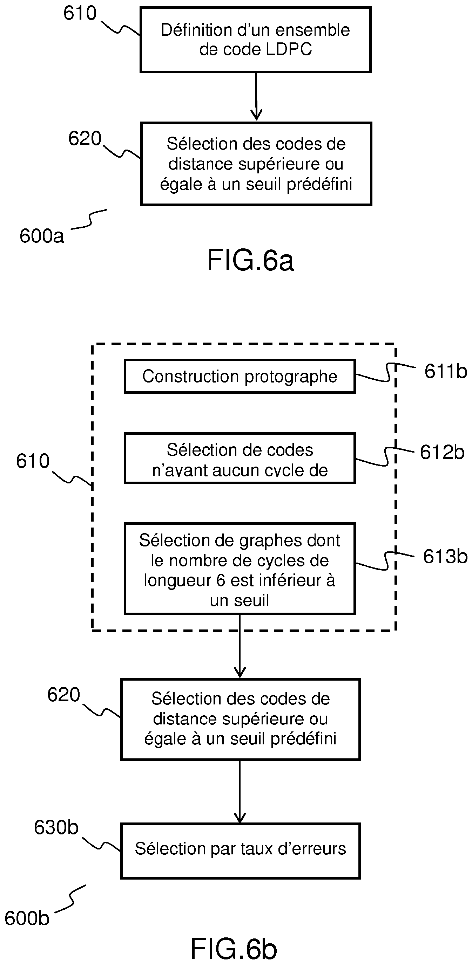

Les figures 6a et 6b représentent deux méthodes de définition d'un code LDPC selon l'invention.

La définition d'un code LDPC présentant de bonnes performances est une tâche complexe. Une solution dite de « force brute » consistant à tester toutes les combinaisons possibles et à retenir le meilleur code est impossible à mettre en œuvre en pratique. En effet, la combinatoire de l'ensemble des codes possibles rend le nombre de codes à tester beaucoup trop important pour pouvoir être testé de manière exhaustive. L'un des objectifs de l'invention est de proposer une méthode de définition d'un code LDPC présentant des performances élevées, pouvant être mise en œuvre, y compris avec des capacités de calcul standard, par exemple en étant mise en œuvre sur une station de travail personnelle.

La méthode 600a est une méthode de définition d'un code LDPC dans un mode de mise en œuvre de l'invention. La méthode 600a comprend une première étape 610 de définition d'un ensemble de codes LDPC admettant une matrice de contrôle représentée par un graphe bipartite de Tanner comprenant 128 nœuds variables du graphe et 64 nœuds contraintes du graphe, chacun desdits codes étant caractérisé en ce que : chacun des nœuds contraintes du graphe est connecté à 7 nœuds variables du graphe ; chacun des cycles du graphe a une longueur supérieure ou égale à 6 ; une deuxième étape 620 de sélection des codes, dont la distance minimale est égale ou supérieure à un seuil prédéfini de distance minimale. Dans un ensemble de modes de réalisation de l'invention, le seuil prédéfini de distance minimale est égal à 14.

La méthode 600a est avantageuse, en ce que l'étape 610 de définition d'un ensemble de codes LDPC peut être mise en œuvre en construisant des graphes de Tanner répondant aux caractéristiques ci-dessus. L'étape 610 permet de créer un ensemble important de codes LDPC, mais néanmoins considérablement moins important que l'ensemble des codes LDPC possibles, tout en s'assurant que les codes LDPC de l'ensemble ainsi produit possède des taux de performances élevés. L'étape 620 permet de filtrer un sous-ensemble de codes LDPC, en supprimant ceux qui, à cause d'une distance minimale trop faible, présenteront des performances réduites.

La méthode 620b est une méthode de définition d'un code LDPC dans un ensemble de modes de mise en œuvre de l'invention. La méthode 620b comprend la première étape 610, et la seconde étape 620. La première étape 610 est séparée en plusieurs sous-étapes successives.

Une première sous-étape 611b consiste à construire un ou plusieurs protographes sur le modèle du protographe 400a. Dans un ensemble de modes de réalisation de l'invention, le protographe est défini par un ensemble de permutations telles que la permutation 440b, et une matrice d'ordres de permutations telles que la matrice 500a. Dans un mode de réalisation de l'invention, la sous-étape 611b consiste à construire l'ensemble des protographes correspondant à l'ensemble des combinaisons d'ordres possibles dans une matrice telle que la matrice 500a. La sous-étape 611b permet de définir une famille de codes LDPC présentant des performances élevées.

Une seconde sous-étape 612b consiste à sélectionner les codes n'ayant aucun cycle de longueur 4. Cette sous-étape peut avantageusement être réalisée en analysant les ordres de permutations entre nœuds du protographe, par exemple selon la méthode définie en référence à la figure 5b. Cette méthode permet de détecter de manière extrêmement simple et rapide les graphes présentant des cycles de longueur 4.

Une troisième sous-étape 613b consiste à sélectionner les graphes pour lesquels le nombre de cycles de longueur 6 est inférieur à un seuil prédéfini. Cette troisième sous-étape permet de ne retenir que les codes LDPC présentant peu de cycles de longueur 6, et donc pour lesquels la probabilité d'une propagation de croyance fausse est réduite.

Dans un ensemble de modes de réalisation de l'invention, le comptage du nombre de cycle de longueur 6 d'un graphe s'effectue de la manière suivante : pour chaque arête du graphe, on enlève l'arête puis on calcule, par exemple en exécutant un algorithme de Djikstra, le plus court chemin entre les deux nœuds aux extrémités de l'arête. Si le plus court chemin trouvé est de longueur 5, alors lorsque l'arête est présente dans le graphe, un cycle de longueur 6 est formé. Afin d'éviter qu'un même cycle ne soit compté deux fois, dans un mode de réalisation de l'invention, une clé est assignée à chaque candidat-cycle. Un ordre est affecté à chaque nœud du graphe. Un cycle est défini par la suite des ordres des nœuds formant le cycle, le nœud de départ étant celui d'ordre le plus faible, et le sens de parcours allant du nœud de départ vers celui des deux voisins du nœud de départ ayant l'ordre le plus faible. Les doublons peuvent ainsi être éliminés, et le nombre de cycles de longueur 6 est compté de manière déterministe.

Dans un ensemble de modes de réalisation, la méthode 600b comprend une troisième étape 630b, consistant à effectuer une simulation du taux d'erreur obtenu par le codage LDPC, sur un grand nombre de blocs, lorsque les blocs sont transmis sur un canal affecté d'un rapport SNR donné, et de ne sélectionner que les candidats pour lesquels le taux d'erreurs est inférieur à un seuil prédéfini. Cette étape permet de sélectionner, de manière déterministe, les codes répondant à des critères de performances. Cette étape seule pourrait, en théorie, suffire à déterminer les meilleurs codes LDPC. Cependant, il s'agit de l'étape nécessitant les calculs les plus lourds. L'ordre des étapes de la méthode 600b permet donc de n'appliquer cette troisième étape 630b qu'à un sous-ensemble de bons candidats présélectionnés par les étapes précédentes. La méthode 600b permet donc d'obtenir des codes LDPC répondant à des critères de performances stricts, tout en nécessitant une quantité de calcul suffisamment faible pour pouvoir être exécutée sur des machines de calcul ordinaires.

Dans d'autres modes de mise en œuvre de l'invention, seulement certaines des étapes de la méthode 620b sont mises en œuvre. Par exemple, la troisième étape 630b peut ne pas être exécutée, et un code LDPC peut être choisi directement à l'issue de la deuxième étape 620, la sous-étape 613b peut ne pas être exécutée, etc... L'homme de l'art pourra, selon ses besoins, définir la méthode la plus adaptée pour obtenir un code LDPC selon l'invention.

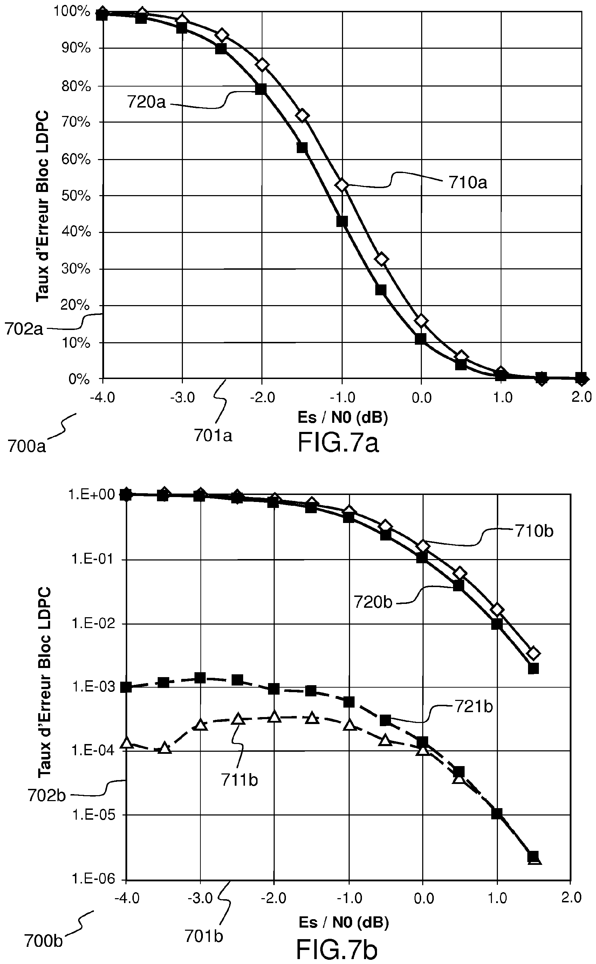

Les figures 7a et 7b représentent une comparaison de performances entre un code LDPC selon l'invention et un code LDPC de l'art antérieur, respectivement suivant une échelle linéaire et une échelle logarithmique.

Le graphique 700a représente une comparaison de performances entre un code LDPC selon l'invention et un code LDPC de l'art antérieur, suivant une échelle linéaire. Le graphique représente l'évolution du PER (Packet Error Rate, Taux d'Erreur Block ou taux de blocs présentant une erreur après décodage par rapport au code original), pour un rapport signal à bruit donné. Ce résultat est produit en encodant un unique bloc selon un code LDPC, simulant un canal bruité, puis simulant le décodage du bloc reçu. Un bloc est décrit comme comportant une erreur, lorsqu'au moins un bit dans le bloc décodé comprend une erreur. L'axe des abscisses 701a représente le rapport signal à bruit du canal, en dB, et l'axe des ordonnées 702a représente le taux d'erreurs en pourcentage, c'est-à-dire le pourcentage de blocs comprenant au moins un bit mal décodé.

La courbe 710a représente l'évolution du PER (Packet Error Rate) obtenu par le code LDPC « Orange Book » développé par la NASA, divulgué par : Consultative Committee for Space Data Systems Short Block Length LDPC Codes for TC Synchronization and Channel Coding Experimental Specification CCSDS 231.1-O-1, Orange Book, April 2015 http://public.ccsds.org/publications/archive/231x1o1.pdf**.** La courbe 720a représente du taux d'erreurs obtenu par un code LDPC selon l'invention, en l'espèce le code représenté par la matrice 500c.

Il peut être observé que le code LDPC selon l'invention présente, pour l'ensemble des rapports signal à bruit, des performances supérieures au code « Orange Book » de l'état de l'art, c'est-à-dire un taux d'erreur sur les blocs LDPC inférieur.

Le graphique 700b représente une comparaison de performances entre un code LDPC selon l'invention et un code LDPC de l'art antérieur, suivant une échelle linéaire. L'axe des abscisses 701b représente le rapport signal à bruit du canal, en dB, et l'axe des ordonnées 702b représente le taux d'erreurs, selon une échelle logarithmique. Les courbes 710b et 720b représentent respectivement l'évolution du taux d'erreurs obtenu pour un bloc par le code LDPC « Orange Book », et le code LDPC selon l'invention, en l'espèce le code représenté par la matrice 500c.

La courbe 711b représente l'évolution du taux d'erreurs non détectées par le code « Orange Book » en fonction du Rapport Signal à Bruit, et la courbe 721b l'évolution du taux d'erreurs non détectées par le code LDPC selon l'invention en fonction du Rapport Signal à Bruit.

Il peut être observé que, bien que ces deux taux soient très faibles à tout rapport signal à bruit, le taux d'erreurs non détectées par le code selon l'invention est plus fort que le taux d'erreurs non détectées par le code « Orange Book » ($10^{-3}$ au lieu de $10^{-4}$). Cependant, la capacité de correction d'erreur du code selon l'invention est significativement plus élevée que celle de l'état de l'art (10% de taux d'erreur pou le code selon l'invention à 0dB, contre 15% dans l'état de l'art). Cette caractéristique permet d'utiliser le code LDPC selon l'invention pour transmettre des informations sur des canaux fortement bruités. Cela permet plus particulièrement, dans le cas de la télérelève, de limiter à la fois le nombre de concentrateurs et l'énergie utilisée par les dispositifs de comptage pour émettre les données, et donc de préserver la durée de vis de la pile des dispositifs de comptage.

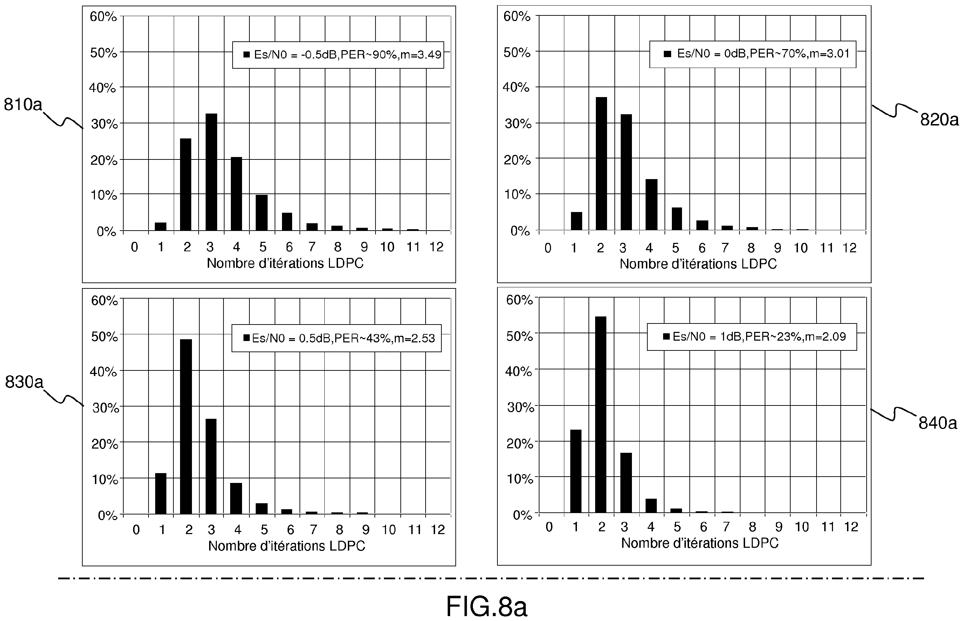

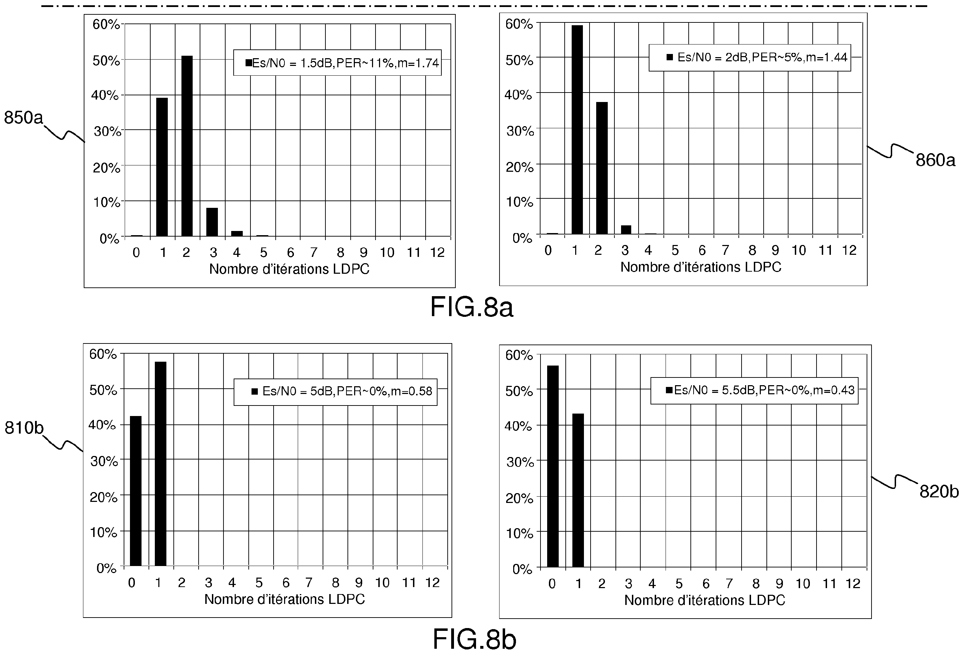

Les figures 8a et 8b représentent des exemples de nombre d'itérations nécessaires pour décoder Code LDPC selon l'invention, respectivement à mauvais et à bon SNR.

La figure 8a représente six graphiques 810a, 820a, 830a, 840a, 850a et 860a représentant chacun la répartition des nombres d'itérations nécessaires pour décoder un bloc, pour un rapport signal à bruit donné. Il est connu que le décodage LDPC utilise plusieurs itérations successives pour décoder les données. Une première étape consiste à vérifier si aucune erreur n'a été transmise. Si c'est le cas, aucune itération de décodage ne sera utilisée (cela correspond aux cas « 0 itérations de décodage » sur les graphiques). Dans le cas contraire, le décodage LDPC comprend des itérations successives de décodage, chaque itération étant suivie d'une phase de vérification que le code décodé ne comprend plus d'erreurs. Si le code ne comprend plus d'erreurs, le décodage est stoppé. Dans le cas contraire, une nouvelle itération de décodage est effectuée, jusqu'à ce que le code ne comprenne plus d'erreurs, ou qu'un nombre maximal d'itérations de décodage soit atteint. Le décodage LDPC étant une opération assez lourde, la limitation du nombre d'itérations de décodage permet d'économiser une puissance de calcul importante au sein du décodeur.

L'histogramme 810a représente la répartition du nombre d'itérations de décodage LDPC nécessaire pour décoder différents blocs encodés par un code LDPC selon l'invention, en l'espèce le code défini par la matrice 500c, pour un signal transmis sur un canal affecté d'un rapport SNR de -0,5 dB. Les nombres d'itérations représentées sur l'axe des abscisses représentent les différents nombres d'itérations de décodage possibles, et l'axe des ordonnées représente le pourcentage de blocs pour lequel un nombre d'itérations donné est nécessaire. Ainsi, pour un rapport SNR de -0,5 dB, environ 2% des blocs ont été décodés en une itération, environ 25% des blocs ont été décodés en deux itérations, environ 32% des blocs ont été décodés en 2 itérations, etc...On observe pour ce SNR un PER (de l'anglais Packet Error Rate, ou Taux d'Erreur Trame de 90% environ), et un nombre d'itérations de décodage moyen de 3,49. Il est à noter que les résultats montrés par les figures 8a et 8b portent sur des paquets comportant 4 blocs, et qu'un paquet est considéré comme ayant une erreur, s'il y a au moins une erreur sur au moins un bloc décodé.

Dans les autres cas représentés en figure 8a, on obtient les résultats suivants :

- Histogramme 820a : canal affecté d'un rapport SNR de 0 dB : PER de 70 % environ, nombre moyen d'itérations de décodage : 3,01 ;
- Histogramme 830a : canal affecté d'un rapport SNR de 0,5 dB : PER de 43 % environ, nombre moyen d'itérations de décodage : 2,53 ;
- Histogramme 840a : canal affecté d'un rapport SNR de 1 dB : PER de 23 % environ, nombre moyen d'itérations de décodage : 2,09 ;
- Histogramme 850a : canal affecté d'un rapport SNR de 1,5 dB : PER de 11 % environ, nombre moyen d'itérations de décodage : 1,74 ;
- Histogramme 860a : canal affecté d'un rapport SNR de 2 dB : PER de 5 % environ, nombre moyen d'itérations de décodage : 1,44.

La figure 8b représente deux graphiques 810b et 820b représentant chacun la répartition des nombres d'itérations nécessaires pour décoder un bloc, pour un rapport signal à bruit donné, dans des cas de fort rapport signal à bruit. Dans ces deux cas, on obtient les résultats suivants :

- Histogramme 810b : canal affecté d'un rapport SNR de 5 dB : PER proche de 0%, nombre moyen d'itérations de décodage : 0,58 ;
- Histogramme 820b : canal affecté d'un rapport SNR de 5,5 dB : PER proche de 0%, nombre moyen d'itérations de décodage : 0,43.

Les résultats expérimentaux présentés aux figures 8a et 8b montrent qu'il est possible, même pour des signaux transmis sur un canal comportant un faible rapport SNR, de borner le nombre d'itérations de décodage, sans diminuer, ou en diminuant de manière marginale, l'efficacité du code LDPC. Par exemple, il serait possible, au vu des résultats ci-dessus, de borner le nombre d'itérations de décodage à 12 sans perte d'efficacité du code LDPC, ou de les borner à 8 ou 10 itérations de décodage, en ne diminuant celle-ci que de manière marginale. Un code LDPC selon l'invention permet donc bien de limiter le nombre d'itérations de décodage du code LDPC, ce qui permet d'effectuer des gains importants de vitesse d'exécution et/ou de puissance processeur au niveau du décodeur LDPC.

Les exemples ci-dessus démontrent la capacité d'un code LDPC selon l'invention de permettre une correction d'erreur efficace lors de la transmission de données, tout en limitant la consommation d'énergie par bit utile transmis, et en limitant la complexité de décodage.

Ils ne sont cependant donnés qu'à titre d'exemple et ne limitent en aucun cas la portée de l'invention, définie dans les revendications ci-dessous.

**Revendications**

1. Encodeur LDPC (Contrôle de Parité de Basse Densité) configuré pour encoder des signaux en utilisant un code LDPC **caractérisé en ce qu'**il admet une matrice de contrôle représentée par un graphe bipartite de Tanner composé de 128 nœuds variables du graphe et 64 nœuds contraintes du graphe, ledit graphe étant tel que :

   - chacun des nœuds contraintes du graphe est connecté à exactement 7 nœuds variables du graphe ;
   - chacun des cycles du graphe a une longueur supérieure ou égale à 6 ;

   dans lequel ledit graphe bipartite de Tanner est un graphe dérivé d'un protographe (400a), ledit protographe comprenant 8 nœuds variables du protographe (410a, 411a, 412a, 413a, 414a, 415a, 416a, 417a), chaque nœud variable du protographe étant un groupe de 16 nœuds variables du graphe et 4 nœuds contraintes du protographe (420a, 421a, 422a, 423a), chaque nœud contrainte du protographe étant un groupe de 16 nœuds contraintes du graphe, dans lequel chaque nœud contrainte du protographe est relié à 7 desdits nœuds variables du protographe selon une matrice, chaque nœud contrainte étant représenté par une ligne de la matrice, chaque nœud variable étant représenté par une colonne de la matrice, chaque cellule de la matrice, définie sur une ligne et une colonne, comprenant la valeur 1 lorsque le nœud variable représenté par la ligne de la cellule et le nœud contrainte représenté par la colonne de la cellule sont reliés, et la valeur 0 dans le cas contraire, ladite matrice étant définie par les valeurs :

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

   ledit encodeur LDPC étant **caractérisé en ce que** la distance minimale du code est égale à 14.

2. Encodeur LDPC selon la revendication 1, dans lequel ledit graphe bipartite de Tanner comprend, pour chaque arête entre un nœud variable du protographe et un nœud contrainte du protographe, 16 arêtes entre un nœud variable du graphe et un nœud contrainte du graphe, lesdites 16 arêtes étant définies par une permutation circulaire selon un ordre compris entre 0 et 15.

3. Encodeur LDPC selon la revendication 2, dans lequel chaque ordre de permutation est défini par une cellule d'une matrice, chaque nœud contrainte étant représenté par une ligne de la matrice, chaque nœud variable étant représenté par une colonne de la matrice, chaque cellule de la matrice, définie sur une ligne et une colonne contenant un ordre de permutation circulaire pour une arrête entre un nœud contrainte représenté par la ligne et un nœud variable représenté par la colonne, ladite matrice (500c) étant définie par les valeurs:

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

4. Encodeur LDPC selon l'une des revendications 1 à 3, **caractérisé en ce que** ledit graphe bipartite de Tanner comprend un nombre de cycles de longueur égale à 6 inférieur à 640.

5. Encodeur LDPC selon l'une des revendications 1 à 4, configuré pour encoder une trame de données comprenant des données de télérelève d'eau, de gaz ou d'électricité.

6. Emetteur configuré pour émettre des trames de données comprenant des données de télérelève d'eau, de gaz ou d'électricité, comprenant un encodeur LDPC selon l'une des revendications 1 à 5.

7. Décodeur LDPC configuré pour décoder des signaux encodés par un code LDPC **caractérisé en ce qu'**il admet une matrice de contrôle représentée par un graphe bipartite de Tanner composé de 128 nœuds variables du graphe et 64 nœuds contraintes du graphe, ledit graphe étant tel que :

- chacun des nœuds contraintes du graphe est connecté à exactement 7 nœuds variables du graphe ;
- chacun des cycles du graphe a une longueur supérieure ou égale à 6 ;

dans lequel ledit graphe bipartite de Tanner est un graphe dérivé d'un protographe (400a), ledit protographe comprenant 8 nœuds variables du protographe (410a, 411a, 412a, 413a, 414a, 415a, 416a, 417a), chaque nœud variable du protographe étant un groupe de 16 nœuds variables du graphe et 4 nœuds contraintes du protographe (420a, 421a, 422a, 423a), chaque nœud contrainte du protographe étant un groupe de 16 nœuds contraintes du graphe, dans lequel chaque nœud contrainte du protographe est relié à 7 desdits nœuds variables du protographe selon une matrice, chaque nœud contrainte étant représenté par une ligne de la matrice, chaque nœud variable étant représenté par une colonne de la matrice, chaque cellule de la matrice, définie sur une ligne et une colonne, comprenant la valeur 1 lorsque le nœud variable représenté par la ligne de la cellule et le nœud contrainte représenté par la colonne de la cellule sont reliés, et la valeur 0 dans le cas contraire, ladite matrice étant définie par les valeurs :

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

ledit décodeur LDPC étant **caractérisé en ce que** la distance minimale du code est égale à 14.

8. Décodeur LDPC selon la revendication 7, dans lequel ledit graphe bipartite de Tanner comprend, pour chaque arête entre un nœud variable du protographe et un nœud contrainte du protographe, 16 arêtes entre un nœud variable du graphe et un nœud contrainte du graphe, lesdites 16 arêtes étant définies par une permutation circulaire selon un ordre compris entre 0 et 15.

9. Décodeur LDPC selon la revendication 8, dans lequel chaque ordre de permutation est défini par une cellule d'une matrice, chaque nœud contrainte étant représentée par une ligne de la matrice, chaque nœud variable étant représenté par une colonne de la matrice, chaque cellule de la matrice, définie sur une ligne et une colonne contenant un ordre de permutation circulaire pour une arrête entre un nœud contrainte représenté par la ligne et un nœud variable représenté par la colonne, ladite matrice (500c) étant définie par les valeurs:

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

10. Décodeur LDPC selon l'une des revendications 7 à 9, **caractérisé en ce que** ledit graphe bipartite de Tanner comprend un nombre de cycles de longueur égale à 6 inférieur à 640.

11. Décodeur LDPC selon l'une des revendications 7 à 10, configuré pour décoder une trame de données comprenant des données de télérelève d'eau, de gaz ou d'électricité.

**12.** Récepteur configuré pour recevoir des trames de données comprenant des données de télérelève d'eau, de gaz ou d'électricité, encodées par un encodeur LDPC selon l'une des revendications 1 à 6, ledit récepteur comprenant un décodeur selon l'une des revendications 7 à 11.

**Patentansprüche**

**1.** LDPC-(Low Density Parity Control)-Encoder, konfiguriert zum Encodieren von Signalen unter Verwendung eines LDPC-Codes, **dadurch gekennzeichnet, dass** er eine Steuermatrix zulässt, die durch einen bipartiten Tanner-Graphen bestehend aus 128 variablen Knoten des Graphen und 64 Zwangsknoten des Graphen dargestellt wird, wobei der Graph derart ist, dass:

- jeder der Zwangsknoten des Graphen mit genau 7 variablen Knoten des Graphen verbunden ist;
- jeder der Zyklen des Graphen eine Länge gleich oder größer als 6 hat;

wobei der bipartite Tanner-Graph ein von einem Protographen (400a) abgeleiteter Graph ist, wobei der Protograph 8 variable Knoten des Protographen (410a, 411a, 412a, 413a, 414a, 415a, 416a, 417a) umfasst, wobei jeder variable Knoten des Protographen eine Gruppe von 16 variablen Knoten des Graphen und 4 Zwangsknoten des Protographen (420a, 421a, 422a, 423a) ist, wobei jeder Zwangsknoten des Protographen eine Gruppe von 16 Zwangsknoten des Graphen ist, wobei jeder Zwangsknoten des Protographen mit 7 der variablen Knoten des Protograph in einer Matrix verbunden ist, wobei jeder Zwangsknoten durch eine Zeile der Matrix dargestellt wird, wobei jeder variable Knoten durch eine Spalte der Matrix dargestellt wird, wobei jede Zelle der Matrix, die auf einer Zeile und einer Spalte definiert wird, den Wert 1 aufweist, wenn der durch die Zeile der Zelle dargestellte variable Knoten und der durch die Spalte der Zelle dargestellte Zwangsknoten verbunden sind, und ansonsten den Wert 0 aufweist, wobei die Matrix durch die folgenden Werte definiert wird:

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

wobei der LDPC-Encoder **dadurch gekennzeichnet ist, dass** der Mindestabstand des Codes gleich 14 ist.

**2.** LDPC-Encoder nach Anspruch 1, wobei der bipartite Tanner-Graph für jede Kante zwischen einem variablen Knoten des Protographen und einem Zwangsknoten des Protographen 16 Kanten zwischen einem variablen Knoten des Graphen und einem Zwangsknoten des Graphen aufweist, wobei die 16 Kanten durch eine kreisförmige Permutation gemäß einer Ordnung zwischen 0 und 15 definiert sind.

**3.** LDPC-Encoder nach Anspruch 2, wobei jede Permutationsordnung durch eine Zelle einer Matrix definiert wird, wobei jeder Zwangsknoten durch eine Zeile der Matrix dargestellt wird, wobei jeder variable Knoten durch eine Spalte der Matrix dargestellt wird, wobei jede Zelle der Matrix, die auf einer Zeile und einer Spalte definiert wird, eine zirkuläre Permutationsordnung für eine Kante zwischen einem durch die Zeile dargestellten Zwangsknoten und einem durch die Spalte dargestellten variablen Knoten enthält, wobei die Matrix (500c) durch die folgenden Werte definiert wird:

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

**4.** LDPC-Encoder nach einem der Ansprüche 1 bis 3, **dadurch gekennzeichnet, dass** der bipartite Tanner-Graph eine Anzahl von Zyklen mit einer Länge gleich 6 von weniger als 640 umfasst.

**5.** LDPC-Encoder nach einem der Ansprüche 1 bis 4, konfiguriert zum Encodieren eines Daten-Frames, der Wasser-, Gas- oder Strom-Femablesungsdaten enthält.

**6.** Sender, konfiguriert zum Übertragen von Daten-Frames mit Wasser-, Gas- oder Strom-Fernablesungsdaten, der einen LDPC-Encoder nach einem der Ansprüche 1 bis 5 umfasst.

**7.** LDPC-Decoder, konfiguriert zum Decodieren von Signalen, die durch einen LDPC-Code codiert sind, **dadurch gekennzeichnet, dass** er eine Steuermatrix zulässt, die durch einen bipartiten Tanner-Graphen bestehend aus 128 variablen Knoten des Graphen und 64 Zwangsknoten des Graphen dargestellt wird, wobei der Graph derart ist, dass:

- jeder der Zwangsknoten des Graphen mit genau 7 variablen Knoten des Graphen verbunden ist;
- jeder der Zyklen des Graphen eine Länge gleich oder größer als 6 hat;

wobei der bipartite Tanner-Graph ein von einem Protographen (400a) abgeleiteter Graph ist, wobei der Protograph 8 variable Protographknoten (410a, 411a, 412a, 413a, 414a, 415a, 416a, 417a) aufweist, wobei jeder variable Knoten des Protographen eine Gruppe von 16 variablen Knoten des Graphen und 4 Zwangsknoten des Protographen (420a, 421a, 422a, 423a) ist, wobei jeder Zwangsknoten des Protographen eine Gruppe von 16 Zwangsknoten des Graphen ist, wobei jeder Zwangsknoten des Protographen mit 7 der variablen Knoten des Protographen gemäß einer Matrix verbunden ist, wobei jeder Zwangsknoten durch eine Zeile der Matrix dargestellt wird, wobei jeder variable Knoten durch eine Spalte der Matrix dargestellt wird, wobei jede Zelle der Matrix, die auf einer Zeile und einer Spalte definiert wird, den Wert 1 aufweist, wenn der durch die Zeile der Zelle dargestellte variable Knoten und der durch die Spalte der Zelle dargestellte Zwangsknoten miteinander verbunden sind, und ansonsten den Wert 0 aufweist, wobei die Matrix durch die folgenden Werte definiert wird:

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

wobei der LDPC-Decoder **dadurch gekennzeichnet ist, dass** der Mindestabstand des Codes gleich 14 ist.

**8.** LDPC-Decoder nach Anspruch 7, wobei der bipartite Tanner-Graph für jede Kante zwischen einem variablen Knoten des Protographen und einem Zwangsknoten des Protographen 16 Kanten zwischen einem variablen Knoten des Graphen und einem Zwangsknoten des Graphen aufweist, wobei die 16 Kanten durch eine zirkuläre Permutation in einer Ordnung zwischen 0 und 15 definiert sind.

**9.** LDPC-Decoder nach Anspruch 8, bei dem jede Permutationsordnung durch eine Zelle einer Matrix definiert wird, wobei jeder Zwangsknoten durch eine Zeile der Matrix dargestellt wird, wobei jeder variable Knoten durch eine Spalte der Matrix dargestellt wird, wobei jede Zelle der Matrix, die durch eine Zeile und eine Spalte definiert wird, eine zirkuläre Permutationsordnung für eine Kante zwischen einem durch die Zeile dargestellten Zwangsknoten und einem durch die Spalte dargestellten variablen Knoten enthält, wobei die Matrix (500c) durch die folgenden Werte definiert wird:

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

**10.** LDPC-Decoder nach einem der Ansprüche 7 bis 9, **dadurch gekennzeichnet, dass** der bipartite Tanner-Graph eine Anzahl von Zyklen mit einer Länge gleich 6 von weniger als 640 umfasst.

**11.** LDPC-Decoder nach einem der Ansprüche 7 bis 10, konfiguriert zum Decodieren eines Daten-Frame, der Wasser-, Gas- oder Strom-Fernablesungsdaten umfasst.

**12.** Empfänger, konfiguriert zum Empfangen von Daten-Frames, die Wasser-, Gas- oder Strom-Femablesungsdaten umfassen, die von einem LDPC-Encoder nach einem der Ansprüche 1 bis 6 codiert werden, wobei der Empfänger einen Decoder nach einem der Ansprüche 7 bis 11 umfasst.

**Claims**

**1.** LDPC encoder (low-density parity-check encoder) configured to encode signals using an LDPC code, **characterised in that** it supports a control matrix represented by a Tanner bipartite graph composed of 128 variable nodes of the graph and 64 constraint nodes of the graph, the graph being such that:

- each of the constraint nodes of the graph is connected to precisely 7 variable nodes of the graph;
- each of the cycles of the graph has a length which is greater than or equal to 6;

wherein the Tanner bipartite graph is a graph derived from a protograph (400a), the protograph comprising 8 variable nodes of the protograph (410a, 411a, 412a, 413a, 414a, 415a, 416a, 417a), each variable node of the protograph being a group of 16 variable nodes of the graph and 4 constraint nodes of the protograph (420a, 421a, 422a, 423a), each constraint node of the protograph being a group of 16 constraint nodes of the graph, wherein each constraint node of the protograph is connected to 7 of the variable nodes of the protograph according to a matrix, each constraint node being represented by a row of the matrix, each variable node being represented by a column of the matrix, each cell of the matrix, defined on a row and a column, comprising the value 1 when the variable node represented by the row of the cell and the constraint node represented by the column of the cell are connected, and the value 0 otherwise, the matrix being defined by the

values:

$$\begin{pmatrix} 1 & 1 & 1 & 1 & 0 & 1 & 1 & 1 \\ 1 & 1 & 1 & 1 & 1 & 0 & 1 & 1 \\ 1 & 1 & 1 & 1 & 1 & 1 & 0 & 1 \\ 1 & 1 & 1 & 1 & 1 & 1 & 1 & 0 \end{pmatrix}$$

the LDPC encoder being **characterised in that** the minimum distance of the code is equal to 14.

2. LDPC encoder according to claim 1, wherein the Tanner bipartite graph comprises, for each peak between a variable node of the protograph and a constraint node of the protograph, 16 peaks between a variable node of the graph and a constraint node of the graph, the 16 peaks being defined by a circular permutation in accordance with an order between 0 and 15.

3. LDPC encoder according to claim 2, wherein each permutation order is defined by a cell of a matrix, each constraint node being represented by a row of the matrix, each variable node being represented by a column of the matrix, each cell of the matrix, defined on a row and a column containing a circular permutation order for a peak between a constraint node represented by the row and a variable node represented by the column, the matrix (500c) being defined by the values:

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}$$

4. LDPC encoder according to any one of claims 1 to 3, **characterised in that** the Tanner bipartite graph comprises a number of cycles having a length of 6 less than 640.

5. LDPC encoder according to any one of claims 1 to 4, configured to encode a data frame comprising remotely read water, gas or electricity data.

6. Transmitter configured to transmit data frames comprising remotely read water, gas or electricity data, comprising an LDPC encoder according to any one of claims 1 to 5.

7. LDPC decoder configured to decode signals encoded by an LDPC code, **characterised in that** it supports a control matrix which is represented by a Tanner bipartite graph composed of 128 variable nodes of the graph and 64 constraint nodes of the graph, the graph being such that:

- each of the constraint nodes of the graph is connected to precisely 7 variable nodes of the graph;
- each of the cycles of the graph has a length greater than or equal to 6;

wherein the Tanner bipartite graph is a graph derived from a protograph (400a), the protograph comprising 8 variable nodes of the protograph (410a, 411a, 412a, 413a, 414a, 415a, 416a, 417a), each variable node of the protograph being a group of 16 variable nodes of the graph and 4 constraint nodes of the protograph (420a, 421a, 422a, 423a), each constraint node of the protograph being a group of 16 constraint nodes of the graph, wherein each constraint node of the protograph is connected to 7 of the variable nodes of the protograph according to a matrix, each constraint node being represented by a row of the matrix, each variable node being represented by a column of the matrix, each cell of the matrix, defined on a row and a column, comprising the value 1 when the variable node represented by the row of the cell and the constraint node represented by the column of the cell are connected, and the value 0 otherwise, the matrix being defined by the values:

$$\begin{pmatrix} 1 & 1 & 1 & 0 & 1 & 1 & 1 \\ 1 & 1 & 1 & 1 & 0 & 1 & 1 \\ 1 & 1 & 1 & 1 & 1 & 0 & 1 \\ 1 & 1 & 1 & 1 & 1 & 1 & 0 \end{pmatrix}$$

the LDPC decoder being **characterised in that** the minimum distance of the code is equal to 14.

8. LDPC decoder according to claim 7, wherein the Tanner bipartite graph comprises, for each peak between a variable node of the protograph and a constraint node of the protograph, 16 peaks between a variable node of the graph and a constraint node of the graph, the 16 peaks being defined by a circular permutation in accordance with an order between 0 and 15.

9. LDPC decoder according to claim 8, wherein each permutation order is defined by a cell of a matrix, each constraint node being represented by a row of the matrix, each variable node being represented by a column of the matrix, each cell of the matrix, defined on a row and a column containing a circular permutation order for a peak between a constraint node represented by the row and a variable node represented by the column, the matrix (500c) being defined by the values:

$$\begin{pmatrix} 0 & 0 & 0 & 0 & & 0 & 0 & 0 \\ 1 & 11 & 4 & 13 & 0 & & 7 & 9 \\ 8 & 10 & 14 & 6 & 11 & 11 & & 15 \\ 9 & 13 & 4 & 3 & 11 & 6 & 8 & \end{pmatrix}.$$

10. LDPC decoder according to any one of claims 7 to 9, **characterised in that** the Tanner bipartite graph comprises a number of cycles having a length of 6 less than 640.

11. LDPC decoder according to any one of claims 7 to 10, configured to decode a data frame comprising remotely read water, gas or electricity data.

12. Receiver configured to receive data frames comprising remotely read water, gas or electricity data encoded by an LDPC encoder according to any one of claims 1 to 6, the receiver comprising a decoder according to any one of claims 7 to 11.

FIG.1

FIG.2

EP 3 327 936 B1

FIG.3

410a

421a

420a

414a

411a

415a

412a

416a

413a

417a

422a

423a

400a

## FIG.4a

410a

421a

440b

## FIG.4b

510a  511a  512a  513a  514a  515a  516a  517a

520a

540a

521a    64 lignes
⟷
contraintes
de parité

522a

523a

64 colonnes ⟷ bits utiles    64 colonnes ⟷ bits de redondance

500a

## FIG.5a

514b

541b  511b  542b

lignes $l_1$ → 

521b

a    c

543b  544b

lignes $l_2$ → 

523b

b    d

543b    544b

colonne $c_1$    colonne $c_2$

## FIG.5b

| 0 | 0 | 0 | 0 |   | 0 | 0 | 0 |
|---|---|---|---|---|---|---|---|
| 1 | 11 | 4 | 13 | 0 |   | 7 | 9 |
| 8 | 10 | 14 | 6 | 11 | 11 |   | 15 |
| 9 | 13 | 4 | 3 | 11 | 6 | 8 |   |

500c

## FIG.5c

610 ———— | Définition d'un ensemble de code LDPC |

620 ———— | Sélection des codes de distance supérieure ou égale à un seuil prédéfini |

600a

## FIG.6a

610 ————

| Construction protographe | ———— 611b |

| Sélection de codes n'avant aucun cvcle de | ———— 612b |

| Sélection de graphes dont le nombre de cycles de longueur 6 est inférieur à un seuil | ———— 613b |

620 ———— | Sélection des codes de distance supérieure ou égale à un seuil prédéfini |

630b ———— | Sélection par taux d'erreurs |

600b

## FIG.6b

FIG.7a

FIG.7b

FIG.8a

850a

■Es/N0 = 1.5dB,PER~11%,m=1.74

Nombre d'itérations LDPC

860a

■Es/N0 = 2dB,PER~5%,m=1.44

Nombre d'itérations LDPC

FIG.8a

810b

■Es/N0 = 5dB,PER~0%,m=0.58

Nombre d'itérations LDPC

820b

■Es/N0 = 5.5dB,PER~0%,m=0.43

Nombre d'itérations LDPC

FIG.8b

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 15306029

- EP 15306546

**Littérature non-brevet citée dans la description**

- Low density parity check codes over GF (q). **DAVEY, M. C. ; MACKAY, D. J.** Information Theory Workshop. IEEE, Juin 1998, 70-71
- SHORT PROTOGRAPH-BASED LDPC CODES. **DARIUSH DIVSALAR ; SAM DOLINAR ; CHRISTOPHER JONES.** Military Communications Conférence. IEEE, 2007
- **GALLAGER, R.** Low-density parity-check codes. *IRE Transactions on information theory,* 1962, vol. 8 (1), 21-28
- **MACKAY, D. J. ; NEAL, R. M.** Near Shannon limit performance of low density parity check codes. *Electronics letters,* 1996, vol. 32 (18), 1645-1646

- SHORT PROTOGRAPH-BASED LDPC CODES. **DARIUSH DIVSALAR ; SAM DOLINAR ; CHRISTOPHER JONES.** Military Communications Conference. IEEE, 2007
- **THORPE, J.** Low-density parity-check (LDPC) codes constructed from protographs. *IPN progress report,* 2003, vol. 42 (154), 42-154
- Consultative Committee for Space Data Systems Short Block Length LDPC Codes for TC Synchronization and Channel Coding Experimental Specification CCSDS 231.1-O-1. Orange Book. Avril 2015